# EUROPEAN PATENT SPECIFICATION

(11) **EP 4 573 403 B1**
(45) Date of publication and mention of the grant of the patent: **30.09.2026**
(21) Application number: 23755345.8
(22) Date of filing: 07.08.2023
(51) Int. Cl.: G02B 26/08, B81C 1/00

(54) **MICRO-OPTICAL ELEMENT**
MIKROOPTISCHES ELEMENT
ÉLÉMENT MICRO-OPTIQUE

(30) Priority: 16.08.2022 DE 102022208488
(43) Date of publication of application: 25.06.2025
(73) Proprietor: Carl Zeiss SMT GmbH, 73447 Oberkochen (DE)
(72) Inventor: SAROV, Yanko, 73447 Oberkochen (DE); HAUF, Markus, 73447 Oberkochen (DE); WEBER, Ulrich, 73447 Oberkochen (DE); AMELING, Ralf, 73447 Oberkochen (DE)
(74) Representative: Rau, Schneck & Hübner Patentanwälte Rechtsanwälte PartGmbB
(86) International application number: PCT/EP2023/071842
(87) International publication number: WO 2024/037916

(56) References cited:
- US-A1- 2014 055 767
- US-A1- 2016 342 095
- US-B2- 10 444 492

## Description

The present application claims priority of German patent application DE 10 2022 208 4888.

The invention relates to a micro-optical element, in particular a micro-mirror. The invention relates further to a micro-mirror array (MMA). Further, the invention relates to an actuator device for a micro-optical element and an actuator system comprising a plurality of such actuator devices. Further, the invention relates to a micro-electromechanical system (MEMS). Further, the invention relates to a facet-mirror for a micro-lithography system, in particular a facet-mirror module. Further, the invention relates to an illumination optics for a microlithography system, an illumination system for a microlithography system, a projection optics for a microlithography system and a microlithography system. Further, the invention relates to the use of a micro-mirror array. Further, the invention relates to a method for producing an optical component. Further, the invention relates to a method for producing micro- or nanostructured elements and such elements.

Micro-mirror arrays, in particular for use in microlithography systems, are known. By way of example, a mirror array including a multiplicity of displaceable individual mirrors is known from WO 2010/049 076 A2. Moreover, both US 2014/055767 A1 and US 2016/342095 A1 disclose mirror arrays. Furthermore, US 10 444 492 B2 discloses a flexure-based, tip-tilt-piston actuation micro-array. The properties of the actuators which set the position the individual mirrors, play a decisive role for the optical function and quality of such a mirror array. Actuator devices for displacing individual mirrors of a mirror array for a projection exposure apparatus are known from DE 10 2013 206 529 A1.

It is an object of the invention to improve a micro-optical element, in particular a micro-mirror, in particular its actuation and/or its thermal conductivity.

This object is achieved by the subject matter of the independent claims.

According to an aspect of the invention a micro-optical element comprises a body with an optical surface, a substrate for suspending the body and an actuator device for tilting the body, wherein the actuator device is arranged on the opposite side of the substrate with respect to the body.

The actuator device can be arranged in a cavity, in particular in a cavity being comprised in a supporting structure for providing mechanical support to the micro-optical element. The supporting structure can in particular be arranged on the rear side of the substrate for suspending the body of the micro-optical element.

The substrate is in particular provided for mechanically holding the body of the micro-optical element.

Herein, a micro-optical element denotes in particular an element with an size, in particular a diameter, in the range of micrometers to at most several centimeters but in particular at most several millimeters, in particular less than 1 mm.

For simplicity's sake, the micro-optical element is also referred to as optical element, only, in the following.

An optical surface denotes a surface for guiding and/or shaping an optical beam. It can in particular be a reflective surface, in particular a mirror surface, or a refractive surface, in particular a lens surface, or a surface with a diffractive structure, in particular a grating. The optical surface can in particular be formed by a multilayer structure which is designed to reflect EUV-radiation.

The optical surface of the body is also referred to as the front side (FS) of the body or, indeed, the optical element. The opposite side is correspondingly referred to as the rear side of the body or the rear side of the body of the optical element.

The micro-optical element can in particular be a mirror, in particular a micro-mirror, in particular an EUV-mirror.

The mirror can have a reflection surface with a maximal size, in particular a maximal diameter, of at most 1 cm, in particular at most 5 mm, in particular at most 3 mm, in particular at most 2 mm, in particular most 1 mm. Other dimensions are possible.

The surface of the mirror element can bear a reflective coating, in particular an EUV reflective coating.

The body of the optical element can be embodied plate shaped. It can in particular be embodied as mirror plate. In the following the body of the optical element is also referred to as mirror plate.

The mirror plate can in particular be suspended on the substrate by suspension means. The suspension means can be embodied as flexures. They can in particular comprise a plurality of springs, in particular leaf springs.

The suspension means can in particular be embodied as a Cardan joint. For details reference is made to DE 10 2015 204 704 A1 and WO 2016/146 541 A1, which are hereby incorporated into the present application in their entirety. The optical element can in particular be suspended by a Cardan joint.

The optical element can in particular be suspended in a way, such that its effective pivot point lies in front of the substrate. The effective pivot point of the optical element can in particular be on the opposite side of the substrate with respect to the actuator device.

The actuator device can be part of a micro-electromechanical system (MEMS). It can itself be a MEMS, in particular MEMS based on microstructured silicon.

The actuator device can be part of an actuator system.

The actuator device can be arranged within a supporting structure. The actuator device can in particular be arranged in one or more cavities comprised in the supporting structure. Further details are described below. The supporting structure can be a physically separate entity with respect to the substrate for holding, in particular suspending, the mirror plate.

The actuator device can be arranged in its entirety on the opposite side of the substrate with respect to the body of the micro-optical element.

The actor actuator device can in particular comprise electrodes, which are arranged on the opposite side of the substrate relative to the body of the optical element. In particular, all electrodes of the actuator device can be arranged on the opposite side of the substrate with respect to the body of the micro-optical element.

Further, the actuator device can be a physically separate entity. In particular, all of the electrodes of the actuator device can be separate, in particular arranged at a distance, to the structural parts of the body of the optical-element or any structural parts directly linked thereto. In particular, the actuator device can be embodied such that none of the actuating electrodes is in physical contact with any of the structural parts of the body of the optical-element or any structural parts directly linked thereto.

In particular, according to an aspect the actuation force generated by the actuator device can be applied or transferred to the body of the micro-optical element mechanically, in particular by mechanical means for transferring such actuation force to the body of the micro-optical element. For the transfer of the actuation force to the body of the micro-optical element the means for transferring such force can be brought in direct physical contact with the body of the micro-optical element.

The front side of the substrate for holding the body of the optical element can define a reference plane with a surface normal. The surface normal of the reference plane corresponds to the surface normal of the optical element, in particular the surface normal of the reflection surface of the mirror, in the neutral, i.e. un-tilted state or position of the optical element.

The actuator device can be part of an actuator system comprising a plurality of such actuator devices.

The actuator device can comprise one or more comb drives. Further details of the embodiment of the actuator device are described below.

The micro-optical element can in particular serve as an element of a microlithography system, in particular an illumination optics of a microlithography system. Other uses of the micro-optical elements are possible.

The microlithography system is also referred to as projection exposure apparatus.

According to an aspect the actuator device comprises means for transferring an actuation force to the body of the micro-optical element. Such means can extend along a length l_{z} in the direction of the surface normal. Such direction is also referred to as longitudinal direction z.

The direction of actuation, in particular the direction of an actuation force exertable by the actuator device on the body of the optical element can in particular be parallel or at least have a component parallel to the direction of the surface normal. In particular, the direction of the actuation force can have a main component parallel to the surface normal. This shall be understood to mean that the projection of the actuation force onto the surface normal (their scalar product) is larger than its projection onto the reference plane perpendicular to the surface normal.

The means for transferring the actuation force can be embodied as physical means, in particular as mechanical means.

The means for transferring the actuation force can in particular comprise one or more pins.

The means for transferring the actuation force can be made of a wafer.

The means for transferring the actuation force can be made of silicon or a silicon compound.

The means for transferring the actuation force can be produced by MEMS-technology.

The means for transferring the actuation force can in particular be mechanically guided, in particular be electro-mechanically guided.

The means for transferring the actuation force to the optical element can be arranged within a cavity in the substrate for holding the body of the optical element. They can in particular be arranged through a cavity, in particular in form of a through silicon passage hole, which in the following is also referred to as through silicon via (TSV), in the substrate.

The length of the means for transferring the actuation force to the optical element, in particular in longitudinal direction, can be at least 1 mm, in particular at least 2 mm, in particular at least 4 mm. Without restricting the scope of the present invention, the extension can be up to 10 mm. The length of the means for transferring the actuation force to the body of the optical element can in particular be at least as large as a side length of the optical surface of the optical element, in particular at least twice as large, in particular at least three times as large, in particular at least five times as large, in particular at least ten times as large as a side length of the optical surface of the optical element.

The means for transferring force from the actuator device to the optical element can be coupled to the body of the optical element such that they can transfer a force in one direction, only or such that they can transfer the force in two opposite directions. They can embodied as pins with a push-only coupling to the body of the optical element or as pins with a push and pull-coupling to the body of the optical element.

According to an aspect the optical element can comprise a sensor. It can in particular comprise one or more integrated sensors. It can, in particular comprise tilt sensors, i.e. sensors for sensing the tilting of the body of the optical element.

The sensor can in particular be arranged on the substrate, in particular on the front side of the substrate. The sensor can in particular be arranged between the mirror plate and the substrate.

The sensor can in particular comprise a plurality of comb electrodes. The comb electrodes can in particular be arranged to extend radially. For further details of the sensor electrodes reference is made to the aforementioned WO 2016/146 541 A1.

According to an aspect the substrate can comprise a plurality of connections, in particular electrical and/or thermal connections. The connections can comprise via-connections, in particular through silicon via (TSV's).

According to an aspect the substrate can comprise an interface, in particular an interface for electrical and/or thermal coupling. The interface can in particular be arranged on the rear side of the substrate.

The cavities in the substrate for the arrangement of the means for transferring force from the actuator device to the body of the optical element are also referred to as pockets.

The substrate can be provided with passages holes for the means for transferring, force from the actuators to the mirrors. The passage holes can be in a wall delimiting the cavity.

According to an aspect the actuator device has a size Az also referred to as vertical length along the direction of the surface normal and a cross-sectional area perpendicular to the surface normal, wherein the cross sectional area of the actuator device is smaller than the optically active area of the optical element, in particular smaller than the reflection surface of the mirror, and wherein the product of the largest diameter of the cross sectional area of the actuator device and its size Az along the direction of the surface normal is larger than the reflection surface.

By that, the space needed for the actuator device in a plane parallel to the reference plane footprint, i. e. can be smaller than the optically active area, in particular the reflection surface, of the optical element whilst the area of the actuator device, which can be used to generate the actuation force can be larger than the optically active area, in particular the reflection surface.

In particular, the actuation force, which can be generated by the actuator device within a given cross sectional area can be increased. This is of particular advantage, if a large number of optical elements are arranged in a densely packed fashion, such that the space behind the optical elements available for arranging the actuator devices is very restricted.

According to a further aspect the actuator device, in particular all of the actuator devices of the optical element, is/are arranged completely within a volume having the same cross-sectional area as the reflection surface. The actuator device, in particular all actuator devices of a given optical element can in particular be arranged completely within a volume extending from the optically active area, in particular extending from the reflection surface in the direction of the surface normal.

According to a further aspect, it is possible to arrange one or more, in particular all of the actuator devices of a given optical element to stand over the cross sectional area of a projection of the optically active area, in particular the reflection surface of the optical element.

The cross sectional area of the volume, in which the actuator devices of a given optical element are arranged can in particular be completely within a projection of the optically active area, in particular of the reflection surface. Alternatively, the cross sectional area of the volume, in which the actuator device, in particular all actuator devices of a given optical element arranged can also be larger than the cross sectional area of such a projection.

Herein, the cross sectional area of the volume, in which the actuator devices are arranged, refers, in particular, to the smallest convex envelope of the actuator devices.

According to a further aspect a micro-mirror array comprising a plurality of mirror elements, in particular according to the previous description, comprises a supporting structure for providing mechanical support to at least some of the mirror elements. The supporting structure can in particular be arranged on the rear side of the substrate for holding the mirror plates.

According to aspect, the supporting structure comprises cavities for receiving actuator devices for displacing the mirror elements.

Herein, the actuator devices can be parts of the optical elements described above.

The substrate for holding the separate mirror elements can be monolithic or multi-part. In particular, it is possible, that each of the mirror elements has a separate substrate. Alternatively, groups of mirrors can be arranged on a common substrate.

The one or more substrates are in particular arranged between the mirror plates and the supporting structure, in particular between the mirrors and the actuators.

As mentioned before, at least some, in particular each of the mirror elements can comprise integrated tilt sensors. The sensors can be arranged on the substrate, in particular between the mirror plate and the substrate. According to an aspect, the supporting structure can comprise different types of electrical and/or thermal connections.

According to a further aspect, the plurality of mirror elements are arranged on a common supporting structure, which is also referred to as holder.

In particular, in case of a hexagonal embodiment of the mirror elements, 19 mirror elements can be arranged on a common supporting structure. Without restricting the scope of the present invention, such supporting structure can comprise 57 or 76 pockets for actuator devices.

The supporting structure can in particular comprise one, two, three, four or more pockets for actuator devices for each mirror.

According to a further aspect the supporting structure can be made of ceramics.

In particular, the supporting structure can be made of ceramic shells. In particular, the supporting structure can be made of a plurality of identical ceramic shells, wherein, in particular, neighboring shells are shifted relative to each other, in particular in a direction perpendicular to the surface normal.

According to a further aspect, in case of a rectangular, in particular square, embodiment of the mirror elements, two pockets for actuator devices can be comprised in the supporting structure for each tilting degree of freedom of the mirror elements. In particular, four pockets per mirror element can be comprised in the supporting structure, in particular two for a first tilting direction and two for a second tilting direction perpendicular to the first tilting direction. These pockets can be in one level or in different levels, as the corresponding actuators can have pins of different lengths.

In case of triangular mirrors there can be three pockets per mirror element in the supporting structure.

Preferably, the number of pockets of the supporting structure for each mirror element is an integer multiple of some order of symmetry of the reflection surface of the mirror elements.

According to a further aspect, the supporting structure is embodied by a low temperature cofired ceramics (LTCC) structure.

The supporting structure can comprise a plurality of vertical electrical connections.

The supporting structure can comprise thermal connections. It can in particular serve as a means for thermal conduction, in particular to aid the heat transport away from the mirror elements towards a heat sink or another cooling structure, which can in particular be arranged on the back side of the supporting structure.

At its front side, i.e. at its surface, which faces the substrate or substrates, on which the mirror elements are arranged, in particular suspended, the supporting structure can have passage holes for the means for transferring the actuator force to the optical elements.

Further aspects related to the actuator device.

The actuator device for the tiltable micro-optical element can comprise a plurality of stacked drives, in particular stacked comb drives. Herein, stacked comb drives shall mean separate comb drives arranged in a stacked fashion and/or a single comb drive with a plurality of combs arranged in a stacked fashion. A combination of these variants is also possible. The number of drives and/or combs can be at least 2, in particular at least 3, in particular at least 4, in particular at least 6, in particular at least 10.

Herein, the micro-optical element can in particular be a micro-mirror according to the preceding description.

The comb drives can in particular be stacked in direction of the surface normal.

According to an aspect several combs are stacked above each other in a direction, which is parallel to the direction in which the actuation force acts.

The comb drives can in particular be embodied to act in parallel, in particular such that the forces generated by each of the comb drives act together.

The comb drives can be made of a single wafer.

The actuator device can in particular comprise multiple on-chip driving levels, in particular multiple on-MEMS-chip driving levels.

The actuator device can be an element, which is physically separate from the mirror element, to which it is to be connected.

The actuator device can in particular be embodied as a vacuum-suitable device.

According to an aspect the comb drives comprise perforated comb fingers.

According to a further aspect, the comp drives also comprise un-perforated comb fingers.

The perforated comb fingers can comprise micro-holes, having a diameter in the range of 1 µm to 5 µm.

The perforation of the comb fingers can be due to an underetching and release process.

Without loss of generality in the following the surface normal is denoted as z-direction. Such direction is also referred to as longitudinal direction or vertical direction.

The actuator device, in particular the orientation of a chip, from which it is made, can be arranged to lie parallel to the vertical direction. In particular, with the z-direction being parallel to the surface normal an in-drive chip plane of the actuator device can be denoted as yz-plane in a local coordinate system. In such a local coordinate system the z-direction corresponds to the height of the combs, in particular the height of the comb fingers. The y-direction corresponds to the width or thickness of the comb fingers and/or their distance, whereas the x-direction corresponds to the depth of the combs, in particular the comb fingers.

In particular, the means for transferring the force from the actuation device to the body of the optical element can be arranged to lie parallel to the vertical direction. This is not absolutely necessary. It can also be arranged obliquely to the vertical direction. It can in particular enclose an angle with the vertical direction of up to 10°, in particular up to 30°, in particular up to 45°, in particular up to 60° or more.

Preferably the angle between the orientation of the means for transferring the force from the actuation device to the body of the optical element and/or the actuation direction and the vertical direction is at most 60°, in particular at most 45°, in particular at most 30°, in particular at most 20°, in particular at most 10°.

The comb electrodes can have a thickness of a few micrometres. They can have an aspect ratio of height : thickness of up to 5 : 1, in particular up to 10 : 1, in particular up to 20 : 1.

The height of the comb fingers can in particular be in the range of 20 µm to 200 µm. For further details reference is made to exemplary description of the embodiment with reference to the figures. Of course, the details provided in the description of the exemplary embodiment are not meant to be limiting.

It could be shown, that with the actuator device according to the present invention a force per unit area of more than 0.1 mN per mm², in particular more than 0.15 mN per mm², in particular more than 0.3 mN per mm², in particular more than 0.5 mN per mm², in particular more than 0.7 mN per mm², in particular more than 1 mN per mm², in particular more than 2 mN per mm², in particular more than 3 mN per mm², in particular more than 5 mN per mm², in particular more than 10 mN per mm² can be generated.

According to a further aspect an actuator device for a tiltable micro-optical element comprises comb fingers having a maximal size f_{z} also referred to as fingers' height in a longitudinal direction z and means for transferring an actuation force from the actuator device to an optical element, wherein such means extend along a length lz in the longitudinal direction z, wherein at least one of the means for transferring the actuation force from the actuator device to an optical element has a length lz which is larger than the maximum heigth fz of the comb fingers. The ratio lz : fz is in particular at least 3 : 1, in particular at least 5 : 1, in particular at least 10 : 1.

The longitudinal direction z herein correspondents in particular to the direction of actuation.

By such embodiment of the actuator device, it is possible to arrange the actuator device at a distance to the optical element to be actuated, wherein such systems can be comparatively large, in particular larger than the height of the comb fingers. Such embodiment can be particularly advantageous, if the physical space directly underneath the optical element is restricted.

According to a further aspect the range of movement of the actuator device, in particular of the means for transferring the actuation force to the body of the optical element, in particular in longitudinal direction z, can be at least 100 µm, in particular at least 200 µm, in particular at least 300 µm, in particular at least 500 µm. It is generally at most as large as the comb fingers' height in longitudinal direction.

According to a further aspect an actuator device for a tiltable micro-optical element, in particular a micro-mirror, has a total size in longitudinal direction z, which is larger than its maximal size in any direction perpendicular thereto. The ratio of the total size of the actuator device in longitudinal direction z to its maximal size in any direction perpendicular thereto can be at least 2, in particular at least 3, in particular at least 5, in particular at least 10.

Further, the ratio of the total size of the actuator device in longitudinal direction z to its minimal size in any direction perpendicular thereto can be at least 5, in particular at least 10, in particular at least 20, in particular at least 50. Further, the ratio of the total size of the actuator device in longitudinal direction z to the range of movement can be at least 10, in particular at least 20, in particular at least 50, in particular at least 100, in particular at least 200, in particular at least 500, in particular at least 1000.

The total size in longitudinal direction z of the comb drive according to the preceding description can be more than 10 mm, in particular more than 20 mm, in particular more than 30 mm, in particular more than 50 mm. It can be as large, as the diameter of a wafer, in particular a silicon wafer.

According to a further aspect, the actuator device can comprise actuation means of different types.

It can in particular comprise at least one of the following actuation means: electrostatic actuation means, Chevron-type actuation means, Piezo-type actuation means.

According to a further aspect the actuator device can be made of a single wafer.

The process for making the actuator device can in particular comprise only MEMS processing steps.

According to a further aspect, a plurality of actuator devices can be made of a single wafer. In particular, the number of actuator devices, which can be made of a single wafer with a diameter of 200 mm can be at least 50, in particular at least 100, in particular at least 200, in particular at least 300, in particular at least 500. By making large number of actuator devices out of a single wafer the costs for each actuator device can be reduced.

According to a further aspect, an actuator system comprises a plurality of actuator devices according to the preceding description, wherein the actuator devices are arranged in a supporting structure. The actuator devices can in particular be arranged in cavities comprised by the supporting structure.

Herein, the supporting structure can in particular be physically separate from the substrate for suspending the optical elements. The supporting structure can in particular be coupled to the optical elements, in particular connected to the optical elements in a separate processing step.

According to an aspect, the supporting structure can comprise a plurality of electrical connections, in particular of different types, and/or thermal connections.

The supporting structure can in particular comprise high voltage electrical comics and/or low voltage electrical connections and/or ground wires and/or thermal connections.

The front types of connections in the supporting structure can be made by different processing technologies and/or can be made of different materials.

The supporting structure can comprise connections to and/or from one or more sensor elements and/or connections to and/or from one or more actuator devices.

According to a further aspect, the supporting structure is made of a plurality of ceramic shells. For further details reference is made to the preceding description as well as to the description of an exemplary embodiment shown in the figures, the latter being understood not to be limiting.

In particular, the supporting structure can be made of LTCC.

According to a further aspect a MEMS for displacing an optical element comprises a substrate for suspending a mirror plate on its front side, a supporting structure for mechanically supporting the substrate and a plurality of actuator devices, in particular according to the preceding description, wherein the supporting structure is arranged on the rear side of the substrate and wherein the actuator devices are arranged within the supporting structure, in particular within cavities or pockets provided in the supporting structure.

As mentioned before, a plurality of mirror plates can be suspended on a common substrate.

The distance between the force generating part of the actuator devices and the mirror plate can be at least 1 mm, in particular at least 2 mm, in particular at least 4 mm.

The actuator devices can be arranged distantly to the mirror plates.

For the transfer of the actuation force to the mirror plates force transmitting means can be used. Such means can in particular comprise pins, which are also referred to as rods. Reference is made to the preceding description.

According to a further aspect, a facet mirror for a microlithography system, in particular a field facet mirror, a pupil facet mirror or a specular reflector, comprises a plurality of micro-mirrors in form of micro-optical elements according to the preceding description and/or one or more micro-mirror arrays according to the preceding description.

The facet mirror can have a modular design, such that a plurality of responding modules can be combined to form a single element, in particular a single facet mirror for a microlithography system. In particular, a plurality of facet mirror modules can be arranged such that their reflection surfaces form a tiling of the total reflection surface.

The micro-optical elements, in particular the micro-mirrors and/or the micro-mirror arrays described above can in particular be used as components of an illumination optics, an illumination system or a projection optics for a microlithography system and thereby as components of such a microlithography system. Such illumination optics, illumination system, projection optics and microlithography system specifically belong to the subject matter of the present invention.

The micro-optical elements, in particular the micro-mirror and/or the micro-mirror arrays described above can more generally be used for a projection system or any application requiring a flexible, shaping of a beam of illumination radiation.

Further aspects of the invention relate to a method for producing an optical component.

Such methods can comprise the following steps:
- providing one or more mirror plates,
- providing a plurality of actuator devices for tilting the mirror plates,
- providing one or more supporting structures with cavities for the arrangement of the actuator devices,
- connecting at least one of the supporting structures to at least one of the mirror plates,
- arranging at least some of the actuator devices in the cavities,
- wherein the actuator devices are arranged in the cavities after the supporting structure has been connected to the mirror plate or
- wherein the supporting structure is connected to the mirror plate after the actuator devices have been arranged in the cavities.

The connection of the supporting structure to the mirror plate can comprise the dimension of at least one of the following types of connections: physical connections, in particular mechanical connections, electrical connections and thermal connections.

Arranging the actuator devices in the cavities can comprise their mechanical fixation within the cavities and/or formation of electrical connections and/or formation of thermal connections.

By providing a micro-lithography system with micro-optical elements, in particular micro-mirrors and/or micro-mirror arrays according to the preceding description a method for producing micro- or nanostructured elements can be improved. Also the micro- or nano-structured elements produced by such methods can be improved.

Further general details and advantages of different aspects are mentioned as follows:
The substrate on which the mirror elements are suspended is in general a mirror-holder body. It can provide mechanical support and/or electrical connections and/or thermal connections to the mirror elements.

The mirror elements are in particular tiltable or pivotable in two axes, in particular to axes perpendicular to each other.

The mirror elements can be suspended by spring elements.

The suspension of the mirror elements can be such that the mirror elements have 2 degrees of freedom.

The mirror elements can be suspended by a cardan joint.

Tilt angle sensors can be arranged between the mirror plates and the holder substrate.

The actuator devices can be embodied as linear actuators.

The actuator devices can be embodied as electrostatic actuators.

The spring element can be a cardanic flexure element.

The tilt angle sensor can be embodied as an electrostatic capacitive tilt angle sensor.

Different actuator devices for tilting a given mirror element in different tilt directions can be arranged stacked above each other. In particular, the means for transferring the actuation force from the actuator devices to the mirror element can have different lengths for different tilt directions. For example, an actuator device for an X-tilt can be arranged below or above an actuator device for a Y-tilt.

In particular, all different actuator devices can be arranged at different levels. Alternatively, two or more, in particular all of the actuator devices or all of the actuator elements of a given group of a single mirror element can be arranged at the same level in the longitudinal direction.

The actuator device can comprise a linear electrostatic comb drive. A multiple actuators "on-chip-arrangement" is possible.

According to an aspect, the means for transferring the force from the actuator device to the mirror element can comprise a pin or a rod which
a) can be extended in at least one direction towards the mirror element and can push onto the rear side of the mirror plate to tilt the mirror, but is free to move/slide on it, or
b) can be extended in at least one direction towards the mirror element to approach and then fixedly engage with the mirror plate or be constrained to a specially dedicated compliant element on the rear side of the mirror plate, or
c) can be extended in at least one direction towards the mirror plate and fixedly engage to a specific area on the rear side of the mirror plate, such area can for example be defined by an indentation: thus the pin can push the mirror plate to tilt it but cannot slide on the plates rear side,
d) can be extended in at least one direction towards the mirror plate and fixedly engage to a specific area on the rear side of the mirror plate, if the pin is permanently fixed it can push and pull the mirror plate,
e) can be extended towards the mirror plate and interacts there with a dedicated cardanic flexure element arranged on the rear side of the mirror plate. Such flexure element can reduce the deformation of the pin when the mirror is tilted.

The means for transferring a force from the actuator device to the mirror element can be coupled to the mirror plate in such way, that it can only push the mirror or in such a way that it can push and pull the mirror.

The comb structures of the actuator device can comprise movable double comb placed between two fixed combs each. They can also comprise single combs only, which can generate a force in one direction, only.

To generate higher driving forces multiple comb levels can be arranged in a stacked fashion in the longitudinal direction.

The pin or rod being the means for transferring a force from the actuator device to the mirror element is in particular fixedly connected to a multilevel comb structure. Such multilevel comb structure can in particular comprise
a) a tree with double sided branches, carrying the movable combs or
b) a frame with the movable branches in between, or
c) the frame with the pin through it, with the movable branches from both sides between the pin and the frame.

At least one of the actuator devices, in particular a plurality of the actuator devices, in particular all of the actuator devices, comprise at least one means for providing a linear guidance, such means being in particular soft in the move direction and sufficiently stiff, in particular at least three times as stiff, in particular at least 10 times as stiff, in particular at least 100 times as stiff, in particular at least 1000 times as stiff, in particular at least 10000 times as stiff, in particular at least 100000 times as stiff, in particular at least 1000000 times as stiff in the parasitic directions. By such linear guidance means parasitic shifts and rotations can be constrained.

The actuator device can comprise one or more end stops to prevent an accidental snap-in of the movable structure of the electrostatic comb actuator to its fixed parts under an electrical potential. By this consequent shortcut, breakage, total damage, etc. can be avoided.

The actuator device can be designed such that none of the electrical supply wires cross each other.

The drive line for supplying an electrical voltage to the comb structures can be arranged in a tunnel structure in the solid arms of the fixed combs. Such tunnel structure can be hollow or filled by an isolator. They can also overcross with an isolation in-between.

The mirror element can be held by an interposer plate. Such interposer plate can comprise connections for the conduction of electrical signals to functionalize the mirror element. It can also comprise thermal connections to conduct heat away from the mirror elements. Further, it can comprise sockets with electrical connections to connect the actuator devices, which are arranged in cavities of pockets of such interposer plate. In particular, the interposer plate is made of our based on LTCC.

The inter-poser plate can be made by fixing together a plurality of shells, in particular ceramic shells, with pockets for the actuator devices.

The shells can have a structured site open to a half space.

The interposer plate can be formed by fixing a plurality of such shells together.

It is possible to just arranged the actuator devices in the pockets and then fix the shells together to form the interposer plate.

The interposer plate can form the supporting structure.

It is also possible to first fit the half open shells together and then place the actuator devices in the pockets, where they are fixed and electrically connected.

The optical elements, in particular the micro-mirrors can have shape of an equilateral triangle, a rectangle, in particular with an aspect ratio unequal 1 : 1, for example an aspect ratio of at least 2 : 1, or square, a pentagon, a hexagon, in particular an equilateral hexagon.

The in plane width of the actuator device can extend the mirror footprint. Alternatively, at least some of the actuator devices, in particular all of the actuator, devices can be arranged completely within the mirror footprint.

The individual actuators can be arranged in a pattern that fills the actuator plane below the mirror plane.

The mirror elements can be arranged in mirror modules, which allow a tiling of a plane.

The in mirror plane width of the actuator devices can be smaller than the size of the mirror elements, in particular smaller than half of the size of the mirror elements. In particular, the actuator devices can be completely covered by the footprint of the mirror element.

The substrate for suspending the mirror elements and/or the mirror plate and/or the suspension, in particular the cardan suspension, and/or the tilt sensors, which can in particular be arranged between the mirror plate and the substrate for suspending the mirrors can be made of silicon or a silicon compound and/or can be produced by MEMS technology, in particular by MEMS processing steps, only.

The actuator devices can be made of silicon or a silicon compound.

The actuator devices can be made by use of MEMS technology, in particular by MEMS processing steps, only.

The actuator devices can be made from silicon on insulator (SOI) or from wafers covered by silicon oxide and with deposited doped poly-silicon as the movable and fixed combs.

Parts like the shuttle, the pin, the suspensions, the end stop etc. can be formed by vertical etching through the device silicon layer. The thickness of such parts can thus be defined by the thickness of the silicon layer. Movable parts can be released by underetching of the oxide as a sacrifice material.

The mirror elements can have a tilt range of at least 30 mrad, in particular at least 50 mrad, and particular at least 100 mrad.

The mirror elements are suitable to work in a vacuum environment.

The mirror elements are suitable to work in an ionized environment.

The mirror elements can tolerate a high thermal load. They can in particular tolerate temperatures of at least 200°C.

In the following, some advantageous features of the actuator devices and/or the suspension system are described briefly:
The actuators can fit within the non-occupied footprint of a single mirror.
The actuators can provide sufficient force/torque for the required range of tilting even in case of stiff suspensions of the mirrors.
The actuators can generate a linear actuation. Thereby side-effects like hysteresis, creep and temperature dependence can be avoided.
The actuators can be embodied and/or comprise electrostatic combs and thin-layered PZTs with additional temperature sensing and compensation.

For the position sensing capacitive combs have been shown to be suitable. In particular, in case of piezo-resistive (PZR) sensors, an additional temperature sensing with mK accuracy and calibration can be provided.

In particular, side effects like temperature dependence of the sensors can be avoided, in particular in the case of electrostatic/capacitive sensors.

The suspension, the actuators, and the sensors can all be placed directly below the mirrors. They can in particular all share the same footprint.

It has been found, that sufficient force/torque to move/tilt the single mirrors of an array can be achieved by an architecture with distant placed thin MEMS-based actuators.

The actuators can have push-only pins or push and pull pins flexibly connected to the mirrors at points.

The pins can be symmetrically situated regarding the centrum of rotation of the mirrors. By means of the pins the mirrors can be tilted.

The actuator force can be generated by multiple on- MEMS-chip driving levels. The driving levels can be ordered vertically (z) along the pin. In this direction the design-size is reasonably uncritical and free to be chosen. It can for example be in the range of 2 mm to 22 mm or even up to 200 mm.

The larger the number of levels with actuator rows, the higher will be the created force.

The mirrors, in particular the mirror array, can be made of silicon or a silicon compound. It can in particular be micromachined from silicon or a silicon compound. It can in particular be made by use of MEMS-processing, in particular by a process comprising MEMS-processing steps, only.

The invention relates in particular to composite mirrors with integrated actuators. The actuators can in particular be monolithically integrated into the mirrors. All parts of the active mirrors can be formed from the same substrate. Alternatively, some of the parts can be fabricated separately and attached / assembled during an assembly process.

The chips for the mirrors can in particular come from different supply chains.

For the tilting of the mirror two independent driving voltages can be applied.

In the following some aspects of the invention are summarized again:
According to an aspect, an active mirror element, comprises s mirror-holder body for a mechanical support and electrical and thermal connection, and a mirror plate, tiltable in two axes and suspended to the mirror holder by at least one spring element allowing a two-dimensional tilt, tilt-angle sensors between the mirror plate and the holder substrate, as the mirror is driven by distant linear electrostatic actuators, placed in the depth with a driving rod (the pin) orthogonal to the holder substrate and approaching the mirror plate through passage holes in the mirror-holder body.

According to an aspect, the spring element is a cardanic flexure element, and/or the tilt-angle sensor is an electrostatic capacitive tilt-angle sensor.

According to an aspect, at least one of the actuators is a separate distinct unit, realized separately from the mirror element (with the mirror plate, the mirror body, the suspension and the sensor), and attached to the mirror unit, forming the mirror device during an assembly step.

According to an aspect, the different actuators for the different tilt directions are stacked above each other and possess different long pins. For example, the actuator for x-tilt is below actuator that for y-tilt, or vice versa, or all actuators are at different levels. In particular, there can be 4 actuators, as the x- and y-actuators are ordered in different levels and are turned in 90 deg to each other, or there can be 3 actuators in 3 levels, turned in 120 deg to each other. In particular, the actuators responsible for different tilt can be orientated with the width (the local y-direction for the drive) along the radial direction on the mirror to the point of the pin's contact.

According to an aspect, at least one of the actuators comprises a linear electrostatic comb drive (more actuators-on-chip possible).

According to an aspect, at least one of the actuators have a pin, which can be extended in two opposite directions (toward and backward), and the pin:
a. is not fixed on the mirror plate. Therefore, this actuator can retract its pin, when one or more of the opposite actuators push the mirror, or
b. is fixed on the mirror plate. Therefore, this actuator can pull, when one or more of the opposite actuators push the mirror, and vice versa.

According to an aspect, at least one of the actuators have a pin, which can be extended in two opposite directions (toward and backward). Wherever this bi-directional move is achieved by a movable grounded (or fixed potential) structure, to which is connected the pin, facilitated with movable combs with fingers in both toward and backward sides. The movable double combs are placed between two fixed on the substrate, independently supplied combs: one in the toward and one in the backward direction, each of which can attract the movable structure to its side, when supplied with a driving voltage.

According to an aspect, the mirror element is driven by the pins of distant linear actuators, as higher driving force/torque is achieved by ordering of multiple comb levels along the pin or in a direction, normal to the plane of the mirror plate.

According to an aspect, at least one of the actuators have a pin, rigidly connected and driven by a multi-level comb structure, as the plurality of movable combs are connected to:
a. a tree with double-sided branches, carrying the movable combs, or
b. a frame with the movable branches in-between, or
c. a frame with the pin through it, with the movable branches from both sides between the pin and the frame

According to an aspect, at least one of the actuators comprises at least one linear guidance, soft in the move direction and sufficient stiff in the parasitic directions and be able to constrain the parasitic shifts and rotations.

According to an aspect, an accidental side snap-in of the movable structure of the liner electrostatic comb actuator to its fixed parts under an electrical potential is prevented by end-stops.

According to an aspect, an actuator comprises a multi-level comb structure for a bi-directional push/pull action of the actuator by application of two different voltages, where the over-crossing of the thin planar supply wires is avoided by:
a. individual connection to fixed comb from each level without over-crossing
b. one drive line propagates on the substrate through tunnels in the solid arms of the fixed combs. These tunnels can be hollow or filled by isolator.

According to an aspect, the active mirror unit comprises 1) a mirror element with mirror-holder body for a mechanical support and electrical and thermal connection, a tiltable mirror plate, cardan suspension, and tilt sensors between the mirror plate, and 2) an interposer plate, which holds the mirror element, conducts electrical signals trough to functionalize the mirror element, conducts the heat away, and has sockets with electrical connections, where are placed and connected the distant actuators. Particular, the interposed is made of or based on LTCC.

According to an aspect, an interposer plate for the active mirror unit has sockets for the distinct actuators, created by fixing together of shells with pockets, as each shell has a structured side, open to the half space. Particular- such interposer and its shells, made of LTCC.

According to an aspect, an interposer plate has sockets for the distinct actuators for the active mirror unit, where:
a. the actuators are placed, fixed and electrically connected to the single half-open shells and the interposer is formed when the shells with the drives are fixed together, or
b. the interposer with the pockets is formed, fitting the half-open shells together, and then the actuators are placed in the sockets and fixed and electrically connected in them.

According to an aspect, within a high fill-factor array of mirror elements or mirror units, the shape or shapes of the single mirrors allows full coverage of the space. The shape of the single mirrors can in particular be chosen form the following list: equilateral triangle, rectangular or squares, pentagon, hexagon.

According to an aspect, within an array of active mirror elements, each driven by distant actuators, in accordance with the above description, the in-plane width of the actuator extends the mirror footprint and the individual actuators are arranged in a pattern that fills the actuator plane below the mirror plane.

According to an aspect, a composite mirror module is covered at high fill factor by arrays in accordance with the above description. The shape or shapes of the mirror arrays can in particular be triangular, rectangular, pentagonal, or hexagonal. These shapes refer in particular to the basic shape of the array. They can have a jagged edge.

According to an aspect, for an active mirror element and unit, driven by distant actuators, in accordance with the above description, the in-mirror plane width of the actuator is comparable, or smaller than, or smaller than the half of the size of the mirror element. Particularly, the actuator element is sufficiently narrow, that its footprint is completely covered by the mirror plate. Thus, an easier shaping and separation of arrays of such mirrors is possible, and higher fill factor for ordering of the arrays can be achieved.

According to an aspect, an active mirror element with a mirror-holder body for a mechanical support and electrical and thermal connection, a tiltable mirror plate, cardan suspension, and tilt sensors between the mirror plate, in accordance with the above description, is made mainly of Silicon, and/or realized by the MEMS technology.

According to an aspect, distinct linear electrostatic actuators for active mirror element, in accordance with the above description, are made mainly of Silicon, and/or realized by the MEMS technology.

According to an aspect, distinct linear electrostatic actuators for active mirror element, in accordance with the above description, are prepared from SOI or wafers covered by SiO2 and with deposited thick doped poly-Si, as the movable and fixed combs, and parts like the shuttle, the pin, the suspensions, the end stops, etc. are formed by vertical etching through the device silicon layer and thus have its thickness. Further, the movable structures: shuttle, pin, moveable combs, suspensions, are foreseen with thickness, or perforated at pitch, comparable with that of the buried oxide and released by underetching of the oxide as a scarified material.

According to an aspect, arrays of active mirror element, and/or distant actuators for their actuation, in accordance with the above description, comprise chips, wherein their chip size is smaller than one exposure field of a standard lithographic stepper or scanner.

According to an aspect, an active mirror element is tiltable in at least one direction of an angle at least 30 mrad, in particular at least 50 mrad, in particular at least 100 mrad. It is in particular suitable to work under low-pressure and/or ionized environment and/or high thermal load.

Further advantages, details and particulars of the invention are evident from the description of exemplary embodiments with reference to the drawings. In the drawings:
- figure 1: shows a schematic representation of a projection exposure apparatus and its constituent parts,
- figure 2: shows a schematic section through a mirror element to show its architecture, in particular the architecture of its actuation in an exemplary way,
- figure 3: shows a schematic view of an array of hexagonal mirrors driven by actuators,
- figure 4A: shows a schematic section through a mirror element to show its architecture, in particular the architecture of its actuation in an exemplary way,
- figure 4B: shows an exemplary cross section of a drive chip with double electrostatic combs for bi-directional push/pull motion and sectional enlargements thereof,
- figure 5A and 5B: shows cross-section of the chips according to fig. 4A or 4B along the line V - V without and with a protection cap,
- figure 6: shows a detail of the comb fingers of the drives according to figures 4 and 5,
- figure 7A to 7C: shows some basic architecture of an exemplary embodiment of a comb drive,
- figure 8: shows a cross-section along the line VIII - VIII through the comb drive according to fig. 7A,
- figure 9 to 11: shows alternative exemplary variants of the drives' architecture, in particular the pins' shuttle; figure 9 shows a variant, in which the pin is away from a frame; figure 10 shows a variant with a tree and a frame; figure 11 shows a variant with a frame with additional suspension elements at the corners,
- figure 12: shows an architecture with pin-tree movable structure and direct wiring without overcrossing of the lines in-between or with other movable structures,
- figure 13: shows a succession of intermediate products of the drives when using a SOI approach,
- figure 14: shows a succession of intermediate products of the drives when using a poly-Si approach,
- figure 15: shows schematically an enlarged view of a bi-directional architecture with crossing signal lines,
- figure 16A to 16E:: shows schematically a process flow for the production of an actuator chip with different intermediate stages (SOI process),
- figure 17: shows a cross section along the line XVII - XVII of the chip shown in fig. 16E,
- figure 18A to 18M:: shows schematically a process flow for the production of an actuator chip with different intermediate stages using a poly-Si process,
- figure 19A and 19B: shows schematically a supporting structure made by aligning and fixing together a plurality of ceramic shells with pockets for actuator devices,
- figure 20A and 20B:: shows a first variant of a production of an assembly with the drive chips and the supporting structure,
- figure 21A and 21B:: shows a second variant of a production of an assembly with the drive chips and the supporting structure,
- figure 22: shows an cross section of an example of the drive chip bonded to a PCB,

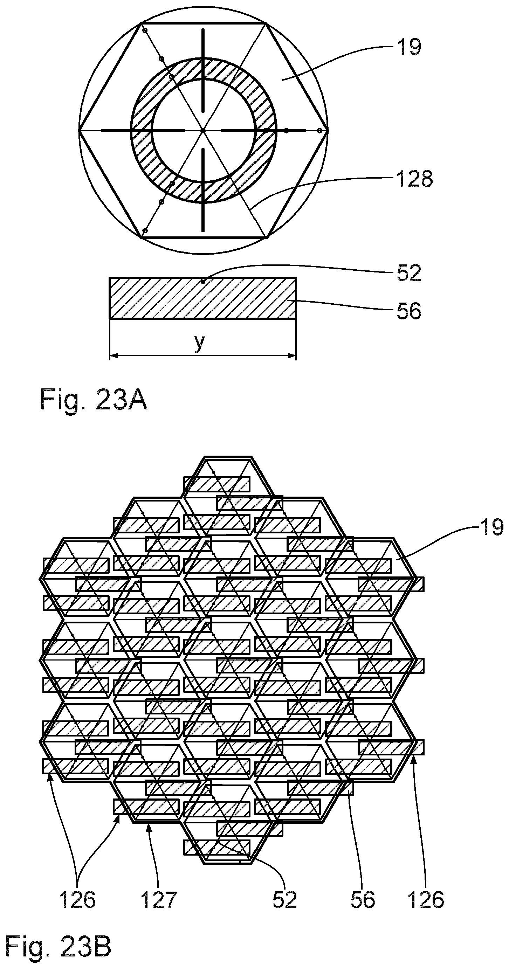

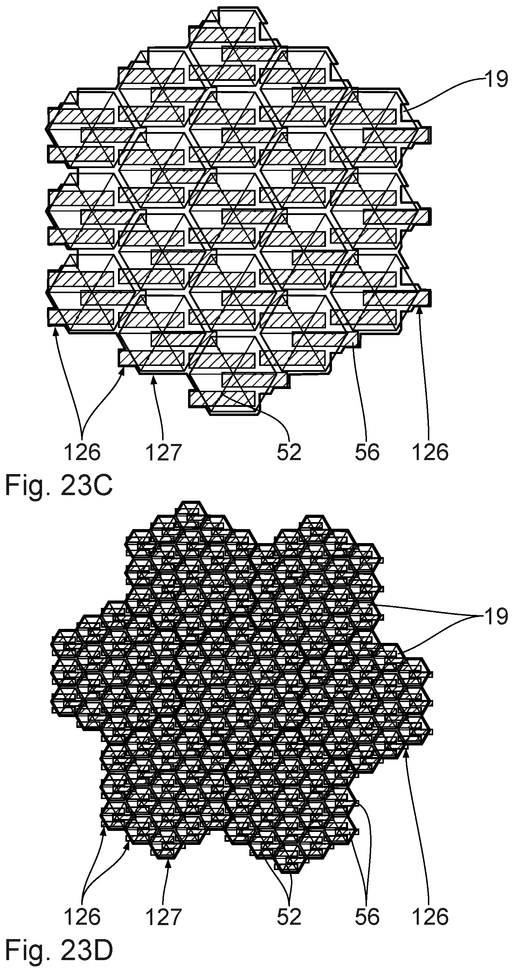

- figure 23: shows an exemplary arrangement of modular micro mirror arrays with actuators,
- figure 24: shows an exemplary arrangement of actuators under micro mirrors,
- figure 25: shows an exemplary arrangement micro mirrors in an array,
- figure 26: shows another exemplary arrangement micro mirrors in an array,
- figure 27: shows an example of a quarter wafer layout with the stepper exposure fields and the actuator chips.

Firstly, the general construction of a projection exposure apparatus 1 (also called lithography system) and the constituent parts thereof will be described. For details in this regard, reference should be made to WO 2010/049076 A2, which is hereby fully incorporated in the present application as part thereof. The description of the general structure of the projection exposure apparatus 1 should only be understood to be exemplary. It serves to explain a possible application of the subject matter of the present invention. The subject matter of the present invention can also be used in other optical systems, in particular in alternative variants of projection exposure apparatuses.

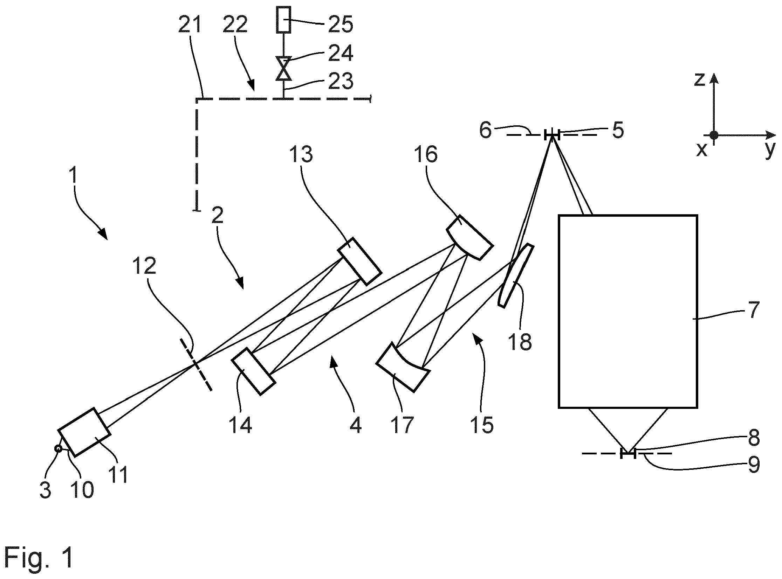

Figure 1 schematically shows a microlithographic projection exposure apparatus 1 in a meridional section. An illumination system 2 of the projection exposure apparatus 1 has, besides a radiation source 3 (also called illumination source), an illumination optical unit 4 (also called illumination optics) for the exposure of an object field 5 in an object plane 6. The object field 5 can be shaped in a rectangular fashion or in an arcuate fashion with an x/y aspect ratio of 13/1, for example. In this case, a reflective reticle (not illustrated in figure 1) arranged in the object field 5 is exposed, said reticle bearing a structure to be projected by the projection exposure apparatus 1 for the production of microstructured or nanostructured semiconductor components. A projection optical unit 7 (also called projection optics) serves for imaging the object field 5 into an image field 8 in an image plane 9. The structure on the reticle is imaged onto a light-sensitive layer of a wafer, which is not illustrated in the drawing and is arranged in the region of the image field 8 in the image plane 9.

The reticle, which is held by a reticle holder (not illustrated), and the wafer, which is held by a wafer holder (not illustrated), are scanned synchronously in the y-direction during the operation of the projection exposure apparatus 1. Depending on the imaging scale of the projection optical unit 7, it is also possible for the reticle to be scanned in the opposite direction relative to the wafer.

The radiation source 3 is an EUV radiation source having an emitted used radiation with a wavelength in the range of between 5 nm and 30 nm. The wavelength of the radiation emitted by the radiation source 3 can in particular be 13,5 nm or 7 nm.

The power of the radiation source 3 can be in the range of 1 kW or more.

The radiation source 3 can be a plasma source, for example a GDPP (Gas Discharge Produced Plasma) source or an LPP (Laser Produced Plasma) source. Other EUV radiation sources, for example those based on a synchrotron or on a free electron laser (FEL), are also possible.

EUV radiation 10 emerging from the radiation source 3 is focused by a collector 11. A corresponding collector is known for example from EP 1 225 481 A2. Downstream of the collector 11, the EUV radiation 10 propagates through an intermediate focal plane 12 before being incident on a field facet mirror 13. The field facet mirror 13 is arranged in a plane of the illumination optical unit 4 which is optically conjugate with respect to the object plane 6. The field facet mirror 13 may be arranged at a distance from a plane that is conjugate to the object plane 6. In this case, it is referred to, in general, as first facet mirror.

The EUV radiation 10 is also referred to hereinafter as used radiation, illumination radiation or as imaging light.

Downstream of the field facet mirror 13, the EUV radiation 10 is reflected by a pupil facet mirror 14. The pupil facet mirror 14 lies either in the entrance pupil plane of the projection optical unit 7 or in an optically conjugate plane with respect thereto. It may also be arranged at a distance from such a plane. In such case it is also referred to as specular reflector.

The field facet mirror 13 and the pupil facet mirror 14 are constructed from a multiplicity of individual mirrors, which will be described in even greater detail below. In this case, the subdivision of the field facet mirror 13 into individual mirrors can be such that each of the field facets which illuminate the entire object field 5 by themselves is represented by exactly one of the individual mirrors. Alternatively, it is possible to construct at least some or all of the field facets using a plurality of such individual mirrors. The same correspondingly applies to the configuration of the pupil facets of the pupil facet mirror 14, which are respectively assigned to the field facets and which can be formed in each case by a single individual mirror or by a plurality of such individual mirrors.

The EUV radiation 10 impinges on both facet mirrors 13, 14 at a defined angle of incidence. In particular, the two facet mirrors are impinged with EUV radiation 10 in the range associated with normal incidence operation, i.e. with an angle of incidence that is less than or equal to 25° in relation to the mirror normal. Impingement with grazing incidence is also possible. The pupil facet mirror 14 is arranged in a plane of the illumination optical unit 4 which constitutes a pupil plane of the projection optical unit 7 or is optically conjugate with respect to a pupil plane of the projection optical unit 7. With the aid of the pupil facet mirror 14 and an imaging optical assembly in the form of a transfer optical unit 15 having mirrors 16, 17 and 18 designated in the order of the beam path for the EUV radiation 10, the field facets of the field facet mirror 13 are imaged into the object field 5 in a manner being superimposed on one another. The last mirror 18 of the transfer optical unit 15 is a mirror for grazing incidence ("grazing incidence mirror"). The transfer optical unit 15 together with the pupil facet mirror 14 is also referred to as a sequential optical unit for transferring the EUV radiation 10 from the field facet mirror 13 toward the object field 5. The illumination light 10 is guided from the radiation source 3 toward the object field 5 via a plurality of illumination channels. Each of these illumination channels is assigned a field facet of the field facet mirror 13 and a pupil facet of the pupil facet mirror 14, said pupil facet being disposed downstream of the field facet. The individual mirrors of the field facet mirror 13 and of the pupil facet mirror 14 can be tiltable by an actuator system, such that a change in the assignment of the pupil facets to the field facets and correspondingly a changed configuration of the illumination channels can be achieved. This results in different illumination settings, which differ in the distribution of the illumination angles of the illumination light 10 over the object field 5.

In order to facilitate the explanation of positional relationships, use is made below of, inter alia, a global Cartesian xyz-coordinate system. The x-axis runs perpendicular to the plane of the drawing toward the observer in figure 1. The y-axis runs toward the right in figure 1. The z-axis runs upward in figure 1.

Different illumination systems can be achieved by means of a tilting of the individual mirrors of the field facet mirror 13 and a corresponding change in the assignment of said individual mirrors of the field facet mirror 13 to the individual mirrors of the pupil facet mirror 14. Depending on the tilting of the individual mirrors of the field facet mirror 13, the individual mirrors of the pupil facet mirror 14 that are newly assigned to said individual mirrors are tracked by tilting such that an imaging of the field facets of the field facet mirror 13 into the object field 5 is once again ensured.

Further aspects of the illumination optical unit 4 are described below.

The one field facet mirror 13 and/or the pupil facet mirror 14 in the form of a multi- or micro-mirror array (MMA) forms an example of an optical assembly for guiding the used radiation 10, that is to say the EUV radiation beam. The field facet mirror 13 and/or the pupil facet mirror 14 is formed as a microelectromechanical system (MEMS). The field facet mirror 13 and/or the pupil facet mirror 14 is composite by few hundreds of MEMS MMA (micro mirror array), or MMA bricks. Each MMA has a multiplicity of individual mirrors 20 arranged in a matrix-like manner in rows and columns in a mirror array 19. A different arrangement is also possible, e.g. hexagonal. The mirror arrays 19 can be embodied in a modular manner. They can be arranged on a carrying structure that is embodied as a base plate. Here, it is possible to arrange essentially any number of the mirror arrays 19 next to one another. Consequently, the overall reflection surface which is formed by the totality of all mirror arrays 19, in particular the individual mirrors 20 thereof, is extendable as desired. In particular, the mirror arrays are embodied in such a way that they facilitate a substantially gap-free tessellation of a plane. The ratio of the sum of the reflection surfaces 26 of the individual mirrors 20 to the overall area that is covered by mirror arrays 19 is also referred to as integration density. In particular, this integration density is at least 0.5, in particular at least 0.6, in particular at least 0.7, in particular at least 0.8, in particular at least 0.9.

The mirror arrays 19 are fixed onto the base plate by means of fixing elements 29. For details, reference is made to e.g. WO 2012/130768 A2.

The field facet (FF) mirror 13 or FF module can comprise several hundred densely stacked mirror elements (field facets). Each mirror element can be actuated in two tilt axes. In such a way more advanced illumination small pupil fill ratio and high flexibility of illumination settings at minimal light loss can be matched.

The individual mirrors 20 are designed to be tiltable by an actuator system, as will be explained below. Overall, the field facet mirror 13 has approximately 100 000 of the individual mirrors 20. The field facet mirror 13 may also have a different number of individual mirrors 20 depending on the size of the individual mirrors 20. The number of individual mirrors 20 of the field facet mirror 13 is in particular at least 1000, in particular at least 5000, in particular at least 10 000. It can be up to 100 000, in particular up to 300 000, in particular up to 500 000, in particular up to 1 000 000.

A spectral filter can be arranged upstream of the field facet mirror 13 and separates the used radiation 10 from other wavelength components of the emission of the radiation source 3 that are not usable for the projection exposure. The spectral filter is not represented.

The field facet mirror 13 is impinged on by used radiation 10 which can have a power of e.g. 840 W or more and a power density of 6.5 kW/m² or more, in particular more than 20 kW/m².

The entire individual mirror array of the facet mirror 13 has e.g. a diameter of 500 mm and is designed in a closely packed manner with the individual mirrors 20. In so far as a field facet is realized by exactly one individual mirror in each case, the individual mirrors 20 represent the shape of the object field 5, apart from the scaling factor. The facet mirror 13 can be formed from 500 individual mirrors 20 each representing a field facet and having a dimension of approximately 5 mm in the y-direction and 100 mm in the x-direction. As an alternative to the realization of each field facet by exactly one individual mirror 20, each of the field facets can be approximated by groups of smaller individual mirrors 20. A field facet having dimensions of 5 mm in the y-direction and of 100 mm in the x-direction can be constructed e.g. by means of a 1 × 20 array of individual mirrors 20 having dimensions of 5 mm × 5 mm through to a 10 × 200 array of individual mirrors 20 having dimensions of 0.5 mm × 0.5 mm.

The tilt angles of the individual mirrors 20 are adjusted for changing the illumination settings. In particular, the tilt angles have a displacement range of at least ± 50 mrad, in particular at least ± 100 mrad, in particular at least ± 120 mrad. An accuracy of better than 0.2 mrad, in particular better than 0.1 mrad, is achieved when setting the tilt position of the individual mirrors 20. An accuracy of better than 0,1 mrad, in particular better than 0,05 mrad, in particular better than 0,02 mrad is required when setting the tilt position of the individual mirrors 20. The individual mirrors 20 of the field facet mirror 13 and of the pupil facet mirror 14 in the embodiment of the illumination optical unit 4 according to figure 1 bear multilayer coatings for optimizing their reflectivity at the wavelength of the used radiation 10. The temperature of the multilayer coatings should not exceed 475 K, in particular at most 425 K during the operation of the projection exposure apparatus 1. This is achieved by a suitable structure of the individual mirrors 20. For details, reference is made to DE 10 2013 206 529 A1, which is hereby fully incorporated into the present application.

The individual mirrors 20 of the illumination optical unit 4 are accommodated in an evacuable chamber 21, a boundary wall 22 of which is indicated in figures 1-and-6. The chamber 21 communicates with a vacuum pump 25 via a fluid line 23, in which a shutoff valve 24 is accommodated. The operating pressure in the evacuable chamber 21 is a few pascals, in particular 3 Pa to 5 Pa (partial pressure H₂). All other partial pressures are significantly below 1 × 10⁻⁷ mbar.

Together with the evacuable chamber 21, the mirror having the plurality of individual mirrors 20 forms an optical assembly for guiding a bundle of the EUV radiation 10.

Each of the individual mirrors 20 can have a reflection surface 26 having dimensions of 0.1 mm × 0.1 mm, 0.5 mm × 0.5 mm, 0.6 mm × 0.6 mm, or else of up to 5 mm x 5 mm or larger. The reflection surface 26 can also have smaller dimensions. In particular, it has side lengths in the µm range or low mm range. The individual mirrors 20 are therefore also referred to as micro-mirrors. The reflection surface 26 is part of a mirror plate 27 of the individual mirror 20. The mirror plate 27 carries the multilayer coating. The mirror plate 27 is also referred to as mirror body or body of the optical element,

With the aid of the projection exposure apparatus 1, at least one part of the reticle is imaged onto a region of a light-sensitive layer on the wafer for the lithographic production of a micro- or nanostructured component, in particular of a semiconductor component, e.g. of a microchip. Depending on the embodiment of the projection exposure apparatus 1 as a scanner or as a stepper, the reticle and the wafer are moved in a temporally synchronized manner in the y-direction continuously in scanner operation or step by step in stepper operation.

Further details and aspects of the mirror array 19 in particular the actuators for displacing, in particular for tilting the mirrors 20, are described below.

An optical element, in particular a micro-optical element, comprises the individual mirror 20 which, in particular, is embodied as a micro-mirror. The individual mirror 20 comprises the mirror plate 27 described above, on the front side of which the reflection surface 26 is formed. In particular, the reflection surface 26 is formed by a multilayer structure. In particular, it has a radiation reflecting property for the illumination radiation 10, in particular for EUV radiation.

In accordance with variants represented in some of the figures, the reflection surface 26 can have a square or a hexagonal embodiment; It can also have a triangular, quadrangular, in particular rectangular or pentagonal embodiment. In general, it has a tile-like embodiment such that a gap-free tessellation of a reflection surface by way of the individual mirrors 20 is possible.

The individual mirror 20 is suspended on a substrate 39 by means of a suspension, in particular in form of a joint 32 which is only depicted schematically in the figures. In particular, it is mounted in such a way that it has two degrees of freedom of tilting. In particular, the joint 32 facilitates the tilt of the individual mirror 20 about two tilt axes. The tilt axes can be perpendicular to one another. They intersect at a central point of intersection, which is referred to as effective pivot point 35.

The optical element can comprise an integrated sensor device 43 for sensing a tilt position of the mirror element 20. The sensor device 43 can be arranged between the mirror plate 27 and the substrate 39. The sensor device 43 is in particular arranged on the front side of the substrate 39, i.e. on the side of the substrate 39 facing the mirror plate 27. It can be placed elsewhere, in the depth vertically, horizontally or even external.

The sensor device 43 can comprise sensor transducer mirror electrodes 45 and sensor transducer stator electrodes 44.

Respectively two sensor transducer stator electrodes 44 that lie opposite one another in respect of the effective pivot point 35 can be interconnected in a differential manner. However, such an interconnection is not mandatory. In general, it is advantageous if respectively two sensor electrodes 44 that lie opposite one another in respect of the effective pivot point 35 are embodied and arranged in such a way that they can be read in a differential manner.

The sensor transducer stator electrodes 44 are embodied as comb electrodes. In particular, the sensor electrodes can comprise sensor transducer stator transmitter electrode that are arranged in alternation with the comb fingers of sensor transducer stator receiver electrode.

Further details of the sensor device are described in WO 2016/146541 A1, which is hereby incorporated by reference in its entirety.

The sensor transducer stator electrodes 44 can be embodied and arranged radially relative to the effective pivot point 35. In particular, they can have comb fingers that extend in the radial direction. This reduces the sensitivity in relation to a possible thermal expansion of the individual mirror 20.

Respectively two sensor units that lie opposite one another in respect of the effective pivot point 35, each with a transmitter electrode and a receiver electrode, can be interconnected in a differential manner or at least readable in a differential manner. This renders it possible to eliminate errors in the measurement of the position of the mirror 20, in particular on account of eigenmodes of the individual mirror 20.

The active constituent parts of the sensor device are arranged on the substrate 39. This renders it possible to measure the tilt angle of the individual mirror 20 directly relative to the substrate 39.

The joint 32 can be embodied as a Cardan-type flexure.

In accordance with a first variant, the joint 32 is embodied as a torsion spring element structure. In particular, it comprises two torsion springs. The two torsion springs have an integral embodiment. In particular, they are aligned perpendicular to one another and form a cross-shaped structure.

The joint 32 can be stiff in view of rotations about the surface normal 36. The joint 32 can be stiff in view of the linear displacement in the direction of the surface normal 36. In this context, stiff means that the natural frequency of the rotational vibrations about the surface normal 36 and the natural frequency of the vibrations in the direction of the surface normal lie above the actuated modes by more than one frequency decade. The actuated tilt modes of the individual mirror lie, in particular, at frequencies below 1 kHz, in particular below 600 Hz. The natural frequency of the rotational vibrations about the surface normal 36 lies at more than 10 kHz, in particular at more than 30 kHz.

The torsion springs can be made of a material with a coefficient of thermal conduction of at least 50 W/(m.K), in particular at least 100 W/(m.K), in particular at least 140 W/(m.K). This helps to conduct the thermal power absorbed by the mirror away from the mirror. What could be achieved by such torsion springs is that the temperature difference between the mirror plate 27 and the substrate 39 is less than 50 K, in particular less than 40 K, in particular less than 30 K, in particular less than 20 K.

The torsion springs may be made of silicon or a silicon compound. The joint 32 is preferably produced from highly doped monocrystalline silicon. This opens up a process compatibility of the production process with established MEMS manufacturing processes. Moreover, this leads to an advantageously high thermal conductivity and a good electric conductivity.

The mirror can preferably be kept at a temperature of less than 200 °C, in particular less than 150° C, in particular less than 100 °C. The heat absorbed by the mirrors has to propagate a long path up to the MMA parts with fixed low temperature. A heat-sink can be provided at the backside of the MMA brick or at the holder behind it.

In another variant of the joint 32, two pairs of bending leaf springs are provided in place of the torsion springs. The joint 32 also has a great stiffness in the horizontal degrees of freedom in this alternative. In this respect, reference is made to the description of the preceding alternative. The design aspects in view of the horizontal stiffness and in view of the mode separation of the parasitic eigenmodes likewise correspond to what was described above.

The variant of the joint 32 is a Cardan-type flexure with orthogonally arranged, horizontal bending springs that are embodied as leaf springs. Respectively two of the bending springs are connected to one another by means of a plate-shaped structure, which is also referred to as an intermediate plate.

Horizontal leaf springs are advantageous from a process point of view. In particular, they simplify the production of the joint 32.

In the following further details of the mirror element 20, in particular of its actuability are described.

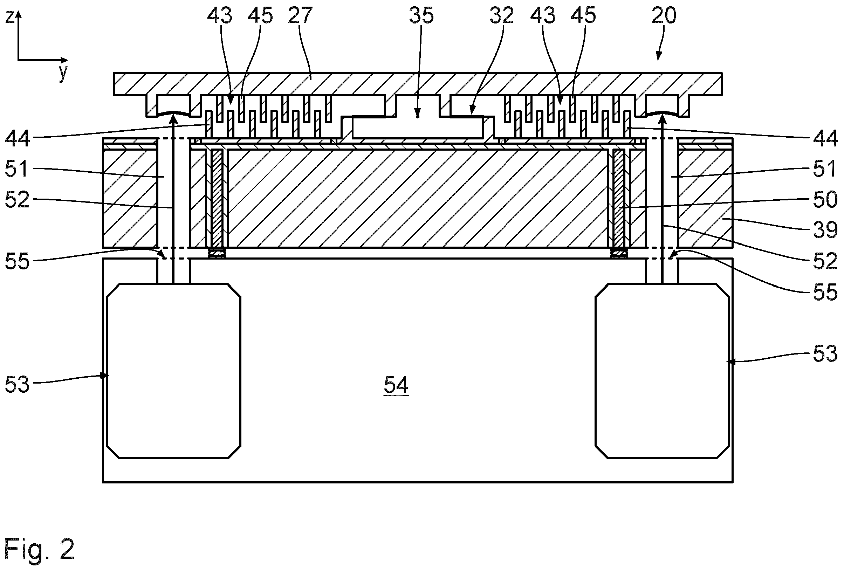

Figure 2 schematically shows the architecture of a flexibly suspended mirror element 20. In fig. 2 a schematical cross-section of the mirror element 20 is shown, in which in particular the following elements and details are depicted: the mirror plate 27, which is suspended on the substrate 39, the sensor device 43 and the joint 32.

Visible are also via-connections like through silicon vias 50 (TSVs) provided in the substrate 39 and an electrical interface at the back side or rear side of the substrate 39.

The substrate 39 comprises passage holes 51for pins 52 of actuator devices 53.

Below the substrate 39 there is arranged a supporting structure 54. The supporting structure 54 can be embodied as low temperature cofire ceramic (LTCC) support.

The supporting structure 54 provides mechanical support for the mirror array 19.

The supporting structure 54 can comprise vertical electrical connections and/or thermal connections. It can serve for heat conduction and/or as interface to a heat sink or other cooling means, provide in particular at its back side.

The supporting structure 54 can comprise pockets 55 for the actuator devices 53.

The supporting structure 54 can comprise passage holes 55 for the actuator devices' 53 pins 52.

The actuator devices 53 can be embodied as actuator chips. They can in particular be embodied as comb drives, details of which are described below. In the following the actuator devices 53 are also referred to as comb drives or simply as drives.

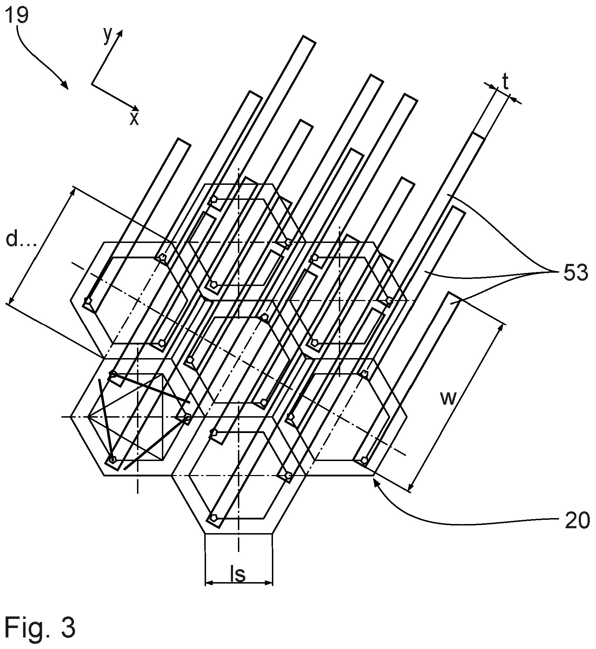

As shown in fig. 3 the mirrors 20 can form a dense mirror array 19. They can for example form an array of hexagonal mirrors 20, i.e. they can have a hexagonal reflection surface 26. This is not understood to be limiting.

The actuator devices 53 can have a width w, shown in the local coordinate system in Fig. 3 in y-direction, which is larger than a side length, in particular larger than a diameter, in particular larger than the maximal diameter d of the reflection surface 26 of the mirrors 20. The ratio of the width w to the maximal diameter dmax of the reflection surface 26, w : dmax, can be 1,5. It can in particular be larger than 1, in particular larger than 2.

The actuator devices 53 can have a thickness t, which is smaller than a side length ls of the reflection surface 26 of the mirrors 20. The ratio of the thickness t to a side length ls of the reflection surface 26, t : ls, can be 1 : 3. It can in particular be at most 1 : 2, in particular at most 1 : 3, in particular at most 1 : 4.

Moreover, the height (z-side in figure 3) of the drive's chip is preferably smaller than one field of the stepper, with which the lithographic exposures for the processing steps are made, in particular the height h of the actuator devices 53 is at most 22 mm.

The height h of the actuator devices 53 can be larger than a side length, in particular larger than a diameter, in particular larger than the maximal diameter dmax of the reflection surface 26 of the mirrors 20. The ratio of the height h to the maximal diameter dmax of the reflection surface 26, h : dmax, can in particular be larger than 2, in particular larger than 3, in particular larger than 5, in particular larger than 10.

The actuator devices 53 can occupy the complete space below the array 19. They can in particular occupy at least 70%, in particular at least 80%, in particular at least 90% of the space below the array 19.

The footprint of each of the actuator devices 53 is in particular smaller than the area of the reflection surface 26. In particular, the sum of the footprint of all of the actuator devices 53 of a given mirror 20 is smaller than the area of the reflection surface 26.

Hexagonal or triangular mirrors 20 can be provided with three actuator devices 53.

Rectangular, in particular square mirrors 20, can in particular be provided with four actuator devices 53.

The pins 52 can contact the mirrors 20 at 95% of the distance of the mirror's 20 corner from the mirror's center.

Some exemplary details are given in the following. They were derived for a hexagonal mirror with a side length ls of 3 mm. They can be scaled with the mirror's size.

It was shown that the actuation range can be larger than 100 µm, in particular larger than 120 µm, in particular larger than 140 µm.

The torque M, which could be generated by the actuator devices 53, can be larger than 1 µN.m, in particular larger than 3 µN.m, in particular larger than 5 µN.m.

The force F, which could be generated by the actuator devices 53, can be larger than 0,2 mN, in particular larger than 1 mN, in particular larger than 10 mN.

The linear stiffness *k_{z-mirr}* of the mirror 20, when the pin pushes, can be larger than 1 N/m, in particular larger than 8 N/m, in particular larger than 25 N/m.

Some basic properties of the actuator devices 53 which have been shown to be feasible are summarized in table 1.

**Table 1. Mechatronical requirements for the actuator chip**

| Feature / Spec | Notation | Value | Unit |
|---|---|---|---|
| Force F | *F* | ≥ 1.1 | mN |
| Range Rg | *Rg* | ≥ ± 142.5 | µm |
| max Comb drive width (y) | *y_{d}* | 18 | mm |
| max Comb drive thickness (x) | *x_{d}* | 1 | mm |
| max Comb drive height (z) | *z_{d}* | 22 | mm |
| max driving voltage | *Uₘₐₓ* | 190 | V |
| z-stiffness | *k_{z-dr}* | ≤ 0.2 · *k_{z-mirr}*~1.6 | N/m |

Without restricting the scope of the present invention, each of these exemplary values can be different by a factor in the range of 0,5 to 2, in particular in the range of 0,3 to 3, in particular in the range of 0,2 to 5.

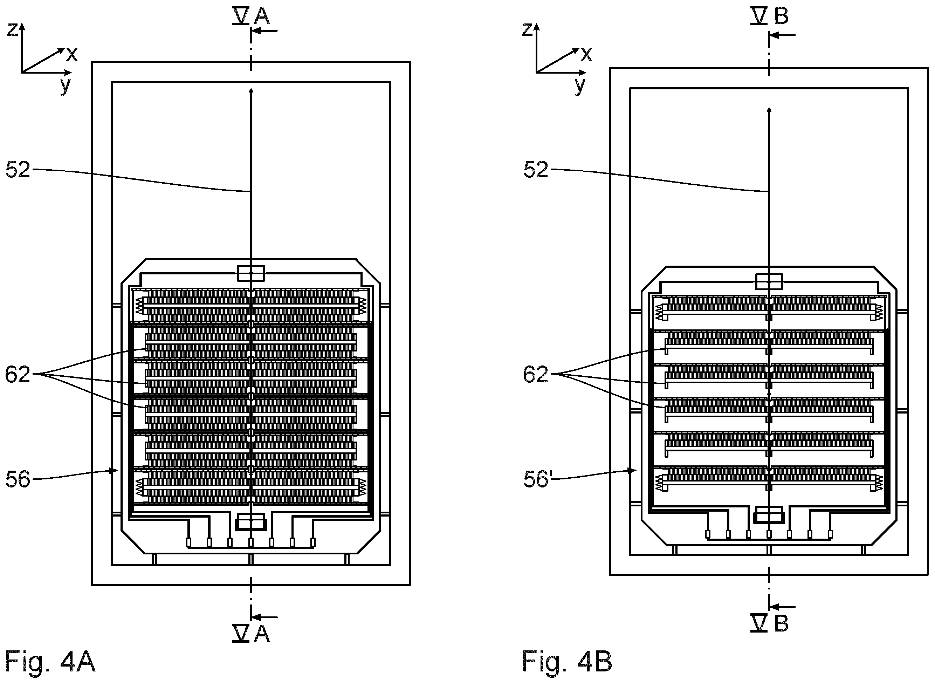

In fig. 4A and fig. 4B, two possible basic designs of the actuator drive chips are schematically shown. The actuation is electrostatic: its advantages are the simple realization and the linearity in differential driving setup. The electrostatic drives make it possible to avoid undesired characteristics like hysteresis, creep, aging, temperature dependence, etc.
Fig. 4A shows a drive chip 56 with double electrostatic combs 57 for bi-directional push/pull motion.
Fig. 4B shows a drive chip 56' with single sided electrostatic combs 57' for uni-directional push only motion.

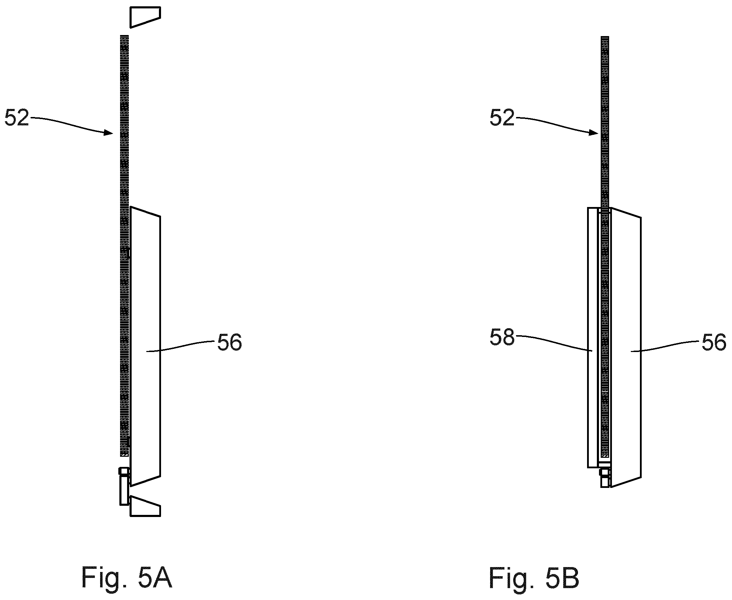

Figures 5A and 5B show a cross-section of the chips according to fig. 4A or 4B along the line V - V without (fig. 5A) and with (fig. 5B) a protection cap 58.

In the implementation example shown in figures 4 and 5 the movable pin 52 is grounded or at a fixed permanent potential. It is shown to be rigidly connected to a tree structure of movable transversal branches with free to move fingers 59. The movable fingers 59 are situated between fixed fingers 60. The fixed fingers 60 are fixedly connected with the chip. They are in particular one-piece with the substrate (wafer) from which the chip is made.

A driving potential can be applied to the fixed fingers 60.

The whole movable structure, including the pin 52, the side branches and the movable fingers 59 are perforated through by small holes 61. The holes 61 can have a diameter of about 2,5 µm. The space between two neighbouring holes 61 can correspond to their diameter. The holes 61 can facilitate the release of the movable structures by underetching of a layer of sacrificial SiO₂ below them. The etching penetrates the holes 61 down to the sacrificial silicon dioxide and solve (etch) it isotropically in depth and laterally at the same rate.

The etching can take part in HF (hydrofluoric) acid.

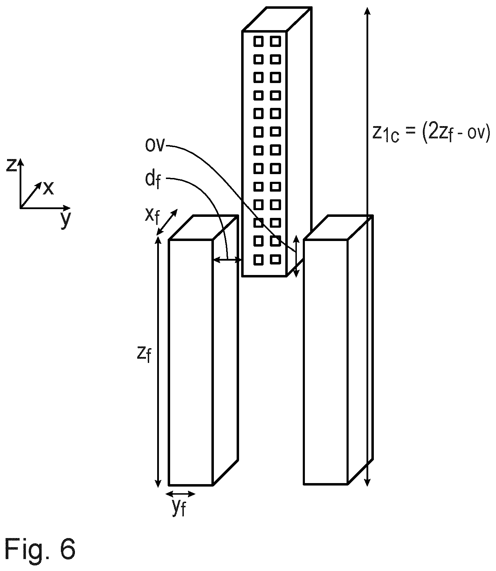

The design of the fingers' pairs and their parameters are shown fig. 6. Some properties of an exemplary embodiment of the fingers are summarized in table 2.

**Table 2: some basic properties of an exemplary embodiment of the comb drive**

| **Fingers** | | | |
|---|---|---|---|
| **Feature** | **Notation** | **Value** | **Unit** |
| actuation voltage: | U | 190 | V |
| hole's size | o | 2.5 | µm |
| finger's height: | z_f=(z_c-ov)/2 | 175 | µm |
| fingers' overlap | ov | 25 | µm |
| finger's width: | y_f=5·o | 12.5 | µm |
| finger's distance (space): | d_f | 3.5 | µm |
| max. fingers' side displacement | Δd_f | 1.5 | µm |
| aspect ratio for building comb: | α_f | 1:10 | -- |
| finger's depth = comb depth | x_f=α_f·o | 25 | µm |

The height zf of the fingers 59, 60 can be at most 10 to 50 times, in particular at most 10 to 20 times, the size of the smallest structure to be etched. With a size of the holes 61 of 2,5 µm and some end-stops at a distance in the range of 1,5 to 2 µm, the fingers' 59, 60 height zf can be chosen as 25 µm. More generally the holes 61 can have a diameter in the range of 1 µm to 5 µm and the fingers' 59, 60 height can be in the range of 20 µm to 200 µm. in particular up to 500 µm or even more.

The fingers' 59, 60 height is chosen to enable the pin's 52 range of movement. In the example the range of movement is 150 µm. This range ca be assured by the distance between the fixed fingers 60 and movable fingers 59, taking into account their overlap. In the implementation the fingers' 59, 60 have a length 175 µm and an overlap of 25 µm. More range requires longer fingers. Some nominal overlap in the range of 10 µm to 50 µm is preferred. This ensures to have remaining overlap in the real case, considering the fabrication tolerances or unproper displacement because the combs do not pull when run from one another. It was found that the value of the overlap is especially important in the configuration of differential driving, when both opposite fixed combs 60 are biased to some potential and the voltage change is applied to both of them, but with opposite sign. Generally, the approach linearizes the force/voltage characteristics, but only as long as opposite combs have remaining overlap.

The fingers width yf can for example be in the range of 5 µm to 50 µm. It can in particular be in the range of 10 µm to 20 µm. It can in particular be between three times and five times as large as the diameter of the holes 61.

The spacing df between the fingers can be in the range of 2 µm to 20 µm. It can in particular be at least 3 µm, in particular at least 5 µm. It can in particular be at most 20 µm. A larger spacing leads to a better security against side snap in, when neighbouring fingers touch each other. A smaller spacing allows the generation of higher forces.

The spacing df is in particular large enough to provide a safety margin against bending of the moveable comb fingers and/or tolerances of their production and/or movement. It could be shown that for the design of the actuator drives according to fig. 4A or fig. 4B the spacing df is 5 to 10 times larger than the maximal deflection of the fingers at maximal displacement. This, undesired effects generated by a side displacement force could safely be avoided.

It has been found that the geometric design of the comb fingers 59, 60 depends on the range of actuation voltages used. The values given above have been found to work for actuation voltages in the range of up to 200 V. With lower voltages the fingers 59, 60 can be made longer and/or thinner.

Application of an actuation voltage will also lead to a side force on the movable comb fingers 59 and thereby on other movable parts of the drive, in particular the pin 52. To account for this, the movable parts of the drive are provided with guidance means 65, providing a lateral stiffness (y-stiffness) of at least 10⁴ N/m, in particular at least 10⁵ N/m, in particular at least 10⁶ N/m. Surprisingly, it could be shown, that such values are feasible and indeed achievable.

With the bi-directional design (fig. 4A) when an electrical potential U+ is applied to e.g. the upper fixed comb part, an attraction force appears between both the movable fingers 59 of and the fixed fingers 60 of the combs and the movable part moves upwards (+z). To move it downwards a voltage U- must be applied to the lower fixed comb.

It could be shown that the force per unit area which could be generated with the actuators according to fig. 4A or fig. 4B was larger than 0,1 mN/mm². The force per unit area which could be generated with the actuators according to fig. 4A or fig. 4B was shown to be up to 1 mN/mm² or even more.

The actuator devices 53, in particular each single comb drive, i.e. each drive chip 56, 56', comprise a plurality of rows 62 of combs. In fig. 4A and 4B a design with six (n=6) rows 62 is depicted. In general the number n of rows 62 can be chosen freely according to needs. A larger number n will enable a larger force, in particular a larger force per unit area to be generatable. The number n of rows 62 of combs can lie in the range of 1 to 100. It will typically lie in the range of 3 to 40, in particular in the range of 5 to 25.

The forces generated by the different rows 62 of combs add together. Thus, the total force and thereby the total force per unit area generatable by the actuator device 53 scales with the number n of rows 62.

The rows 62 are arranged stacked behind each other. They are in particular stacked in the direction of actuation and/or in the direction of movement of the pin 52.

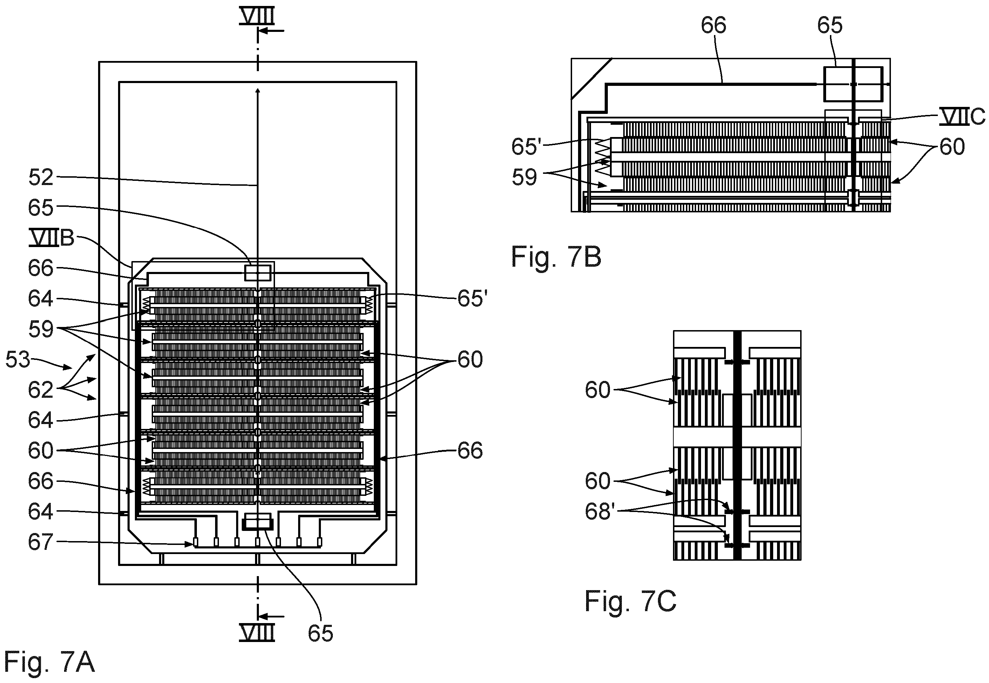

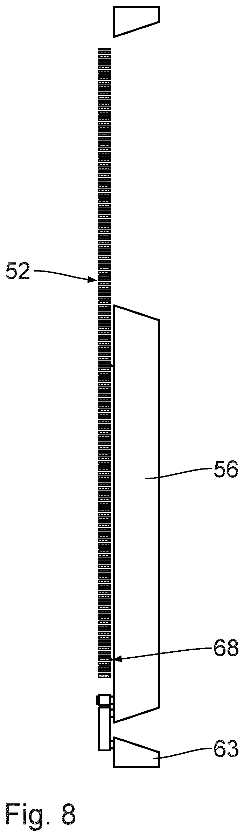

The basic architecture of an exemplary embodiment of a comb drive chip 56 within its wafer's frame 63 is shown in fig. 7A to 7C (top view) and fig. 8 (cross-section view). In these figure are shown:
- the driver chip 56 within its wafer's frame 63, hold by thin bridges 64,
- the pin 52 with the movable tree-structure of branches with the movable combs / fingers 59,
- the fixed combs 60 for upward (+z, push) and downward (-z, pull or retract) move of the pin 52,
- the wiring 66 to the fixed + and - combs 60 and the (ground) GND connection to the pin 52 and movable combs with their fingers 59, connected through the guidance structures 65, 65', and the corresponding bonding pads 67,
- the pin + shuttle's upper and lower guidance 65 (some optional additional guidance structures 56', in particular lateral guidance structures, may be added for more stability and/or such ones, that are stiff in some direction and thus restrict the related parasitic displacements).

The guidance has two important functions:
→ to provide low stiffness in the move direction and high in the parasitic shift & rotation directions
→ to connect the movable structure to GND
   - the end-stops 68, 68', which prevent a collision between the movable and the fixed parts. Without applied voltage such collision can cause the fine parts to break. When a voltage is applied, a contact will also cause a shortcut and could damage the chip electrically and/or mechanically. The y and z end-structures are anchor-type, i.e. fixed on the substrate and in slightly smaller distance to the movable structure, that the distance to the structure under voltage. The z-end stops 68' also determine the move range: 145 µm, 5 µm before the GND and supplied structures to come in contact. The y-end-stop 68' prevents a possible side snap-in. The x end-stops 68 are on the pin 52 and the branches and prevents the pin 52 and shuttle to lay on the substrate and possibly to stack on, due to the molecular adhesive forces. It should be noted that the tree-shuttle shall never move to the end-stops 68, 68', and/or slide on them. They are urgency assurance, e.g. by shock, transport, earthquake, etc. By their physical design and, in particular, together with a proper guidance, they assure the proper move of the shuttle and prevent it to move/rotate in the constraint directions.

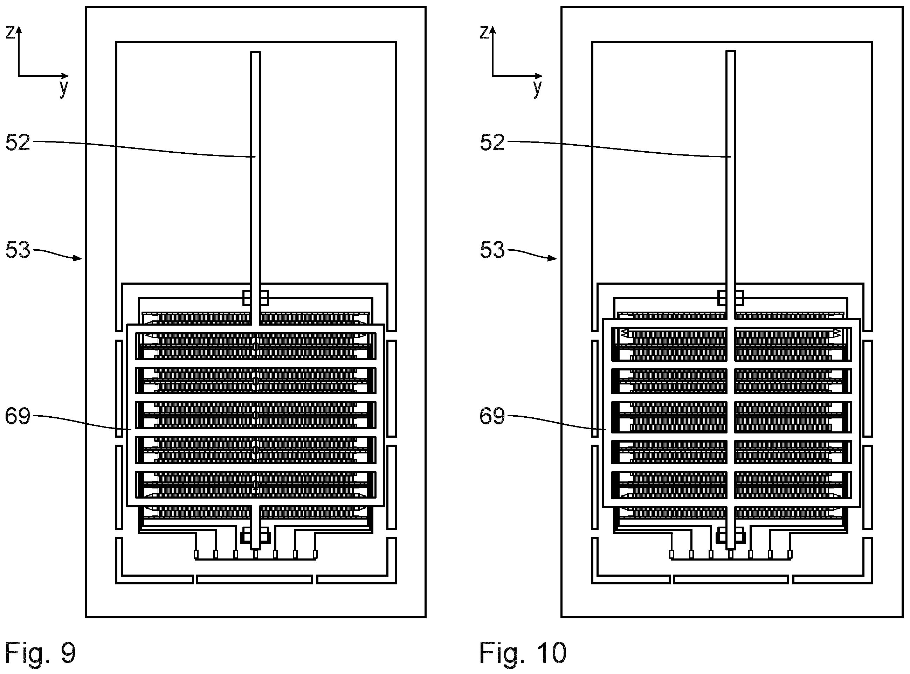

Alternative exemplary variants of the drives' architecture are shown in figures 9 to 11.

The embodiment shown in figure 7A is not the only architecture solution. Since the branches of the movable parts are not infinitely stiff, any guidance is not perfect and even a µm bending of the branches, or a mrad x-rotation of the pin's tree would result in a µm displacement of the outer movable fingers. With the variants of the drives' architecture shown in figures 9 to 11 such displacement can be reduced, more preferably avoided.

As shown in fig. 9 the central connection of the branches to the pin 52 can be replaced with a side connection to a frame 69. The pin 52 can be rigidly connected to the frame 69, in particular to an upper and a lower part of the frame 69. The frame 69 is part of a shuttle and/or is also referred to as shuttle.

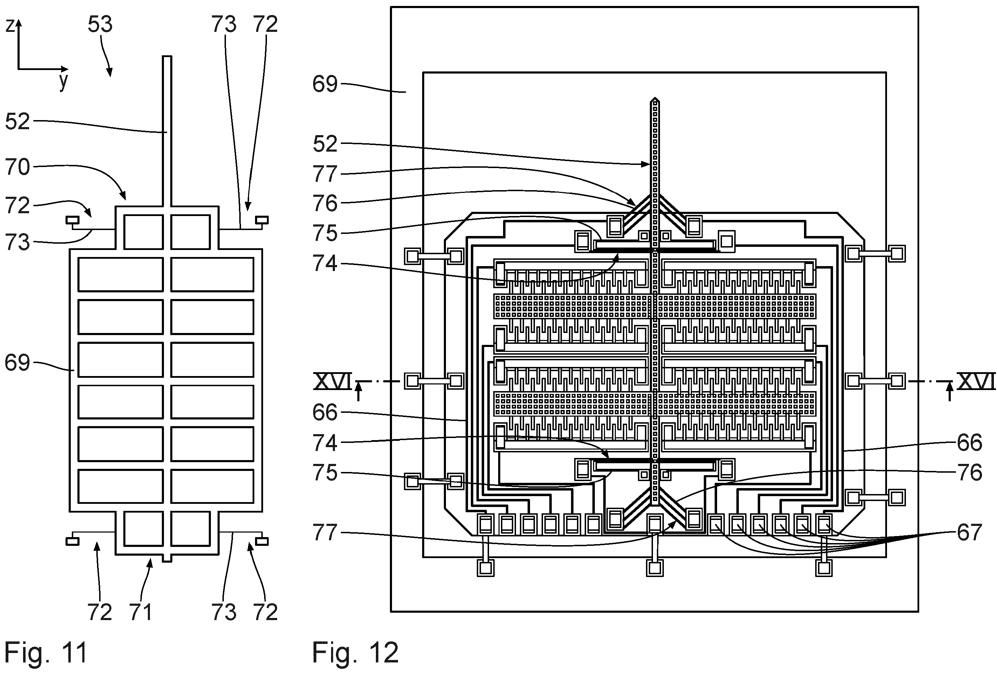

Pin 52 and frame 69 can also be combined (fig. 10 and 11). Here the pin 52 divides the frame 69 in two and additionally strengthens it.

The frame 69 may be rectangular (fig. 10) or with more-complicated form (fig. 11).

In the example shown in fig. 11, the upper branch 70 and lower branch 71 are narrower than the middle part. By this a space for an additional guidance for the shuttle is provided. The frame 69 (shuttle) can be guided by some suitable means of guidance. As means of guidance can serve some elastic structure, in particular some springs. In the particular embodiment shown in fig. 11 L-springs 73 form the means of guidance. They are a modification of leaf-springs, as the shorter part to the anchor offers a length compensation by a z-move. Moreover, such spring system would constrain some parasitic motions like e.g. y-shift and Rz rotation.

It has been found, that for some aspects it can be advantageous, if the fixed combs 60 are open, in particular freely accessible, from the side. This allows them to be connected electrically by extension structures or signal wires without overcrossing of the lines in-between or with other movable structures. An example of such architecture is shown is the uni-directional comb drive shown in figure 4B. An architecture solution for bi-directional wiring without crossing of wires is shown in figure 12.

Some benefits of this architecture are the simpler production technology, requiring fewer steps and the reduced risk of shortcuts.

The architecture of the comb drives 53 may combine different guidance means 65, 65' for suppression of different constrained degrees of freedom (DoF).

It is also possible to combine different actuators or actuator elements and/or mechatronical elements like different quidances, sensors, etc., in particular different types of actuators or actuator elements in one and the same drive. For example short stroke actuators or actuator elements and long stroke actuators or actuator elements can be combined in one drive.

Such example is schematically shown in fig. 12.

Moreover, additional to the comb actuator the drive 53 shown in fig. 12 comprises two chevron actuators 77: one above the upper and one below the lower Π-guidance 75.

Here, the drive 53 comprises a combination of straight 74, Π- 75 and W- 76 leaf springs.

The chevron actuators 77 are based on the principle of thermal expansion: when current is set through the beams, they heat and expand. These actuators possess small range but create high force.

The combination of the comb actuators with one or more other types of actuators, for example piezo actuators, is also possible.

In the following some aspects and details of a possible method for the production of the actuator devices 53 are described.

Preferably the process for the production of the actuator devices 53 is kept as simple as possible, enabling a shorter development duration, less risky and high-yield manufacturing, and lower costs by a volume fabrication. A possible fabrication sequence will be presented below.

The actuator devices 53 are built as MEMS. They can preferably be build using only MEMS-processing steps.

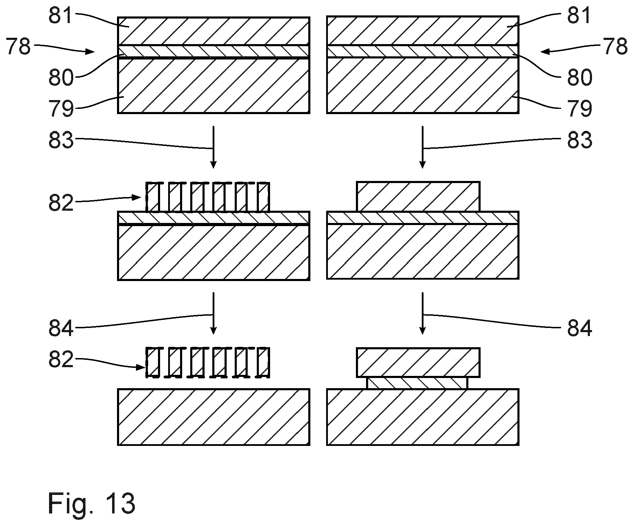

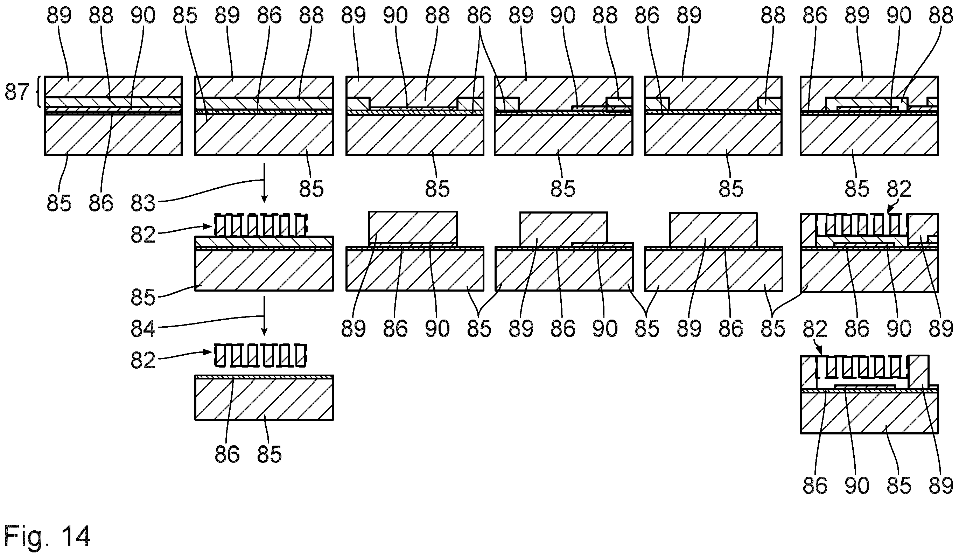

For the comb drives 53 described above in particular two technologies have shown to be feasible and advantageous: the SOI (silicon-on-insulator) approach (fig. 13) and the poly-Si approach (fig. 14). Both of these approaches are derivatives of the poly-MUMPS and SOI-MUMPS. MUMPS stays for Multi-User Manufacturing Process, which allows inexpensive access to silicon by sharing design on the same wafer. The baseline process of the MUMPs program is the 3-layer polysilicon surface micromachining process known as PolyMUMPs.

The SOI approach (fig. 13) ca in particular be used by architectures and wiring shown in fig. 12. It offers a particularly simple method for the production of the actuator devices 53.

The start is with SOI wafers 78: a holder wafer 79 with a thick buried oxide 80 (BOX) and upper device layer 81. The BOX 80 can have a thickness in the range of 2-3µm. The upper device layer 81 can be as thick as will be the movable and fixed structures, for example 25 µm.

During a first etching step 83 the upper device layer 81 can be etched vertically with an etch stop on the BOX 80, leaving dense perforated structures 82 with holes size similar to the BOX 80 thickness, and large-base structures. The size of these base structures can be several to ten or more times the BOX 80 thickness.

Then, during a second etching step 84, the BOX 80 is etched isotopically in HF acid, thereby underetching and releasing the movable, perforated structures (fig. 13, left half) and slightly underetching, but leaving fixed the large base structures (fig. 13, right half). In that way the movable 59 and fixed combs 60 and the guidance 65, 65' with a fixed anchor and vertical free leaves, connected to the pin or the branches can be formed.

The wires are only schematically shown. They can be long narrow fixed paths of doped poly-Si, as high as the combs 59, 60 and the pin 52.

The poly-Si approach (fig. 14) starts with a simple Si wafer 85, covered completely by a silicon nitride (SiNx) layer 86. Then, by consequent deposition, structuring, next material deposition, optional planarization, etc., combinations of different layers' stacks 87 are build. The sequence of the materials over the SiNx layer can e.g. be: a 0.5 µm thin highly doped poly-Si layer, in particular for planar wiring, a sacrificial 2-3 µm thick SiO₂ layer 88, and a doped poly-Si layer 89. The poly-Si layer 89 can be as thick as the movable and fixed structures, for example 25 µm. More generally it can be in the range of 10 µm to 200µm. The full stack is shown in fig. 14 on the left.

Regions with different combination of these materials can be created by proper structuring.

The released free structures are done like in the SOI approach: by perforating the thick poly-Si over the sacrificial SiO₂ and the underetching of the later (fig. 14, second column from the left).

For the fixed and electrically connected combs or anchors the oxide must be etched away and the thick poly-Si to be deposited on the thin highly doped poly-Si layer 90 (fig. 14, 3^{rd} and 4^{th} column).

An anchor can be just fixed and not electrically connected. For this the thick poly-Si can lay on the nitride (fig. 14, 5^{th} column).

The electrically connected combs may rest on the thin poly-Si wire in some areas. They get the potential and can further stay as fixed anchors (fig. 14, 4^{th} col.).

A clever feature - a signal/wire crossing rigid bridge, can be realized employing the potential of this technology. Here, part of the fixed thick arm for the fixed comb fingers can propagate over a wire for another signal, covered and electrically isolated by sacrificial SiO₂ (fig. 14, right hand side). The signal crossing can be realized as shown in (fig. 14, right hand side, upper and middle scheme).

Alternatively, the crossing area also can be perforated, and by the SiO₂ etch step the oxide can be removed and the bridge will stay above another signal wire (air isolation: fig. 14, right hand side, lower scheme). In that way, a better electrical isolation can be realized and the risk of shortcut can be reduced.

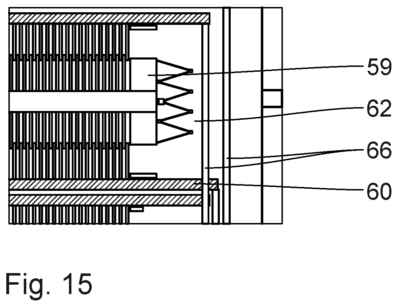

Such signal crossing is implemented by the bi-directional architecture solutions shown in fig. 4A and 7A. A magnified schematic view is shown in fig. 15.

For the architecture solutions with frame 69 as shown in fig. 9 to 11 the driving voltage lines must propagate in proximity below the grounded frame 69. Thus, when looked from the top, there can be 2 (n-1) crossings. These crossings can be avoided by the design with tree and branches, which are open at the end.

The gap g between the frame 69 and the signal lines of the wiring 66 is given by the difference between the thickness of the BOX layer 80, for example about 2,5 µm, and the thickness of the poly-Si wire (upper device layer 81), for example about 0.5 µm. Thus, the gap can be in the order of about 2 µm.

The frame and the lines form plate capacitors at these areas and the frame is attracted toward the substrate at every cross by a x force when a driving voltage is applied . In addition the whole frame 69 is pulled toward the floor by an electrostatic force. However, with the design shown above, there is another force, which counteracts the pull-in force toward the driving wires. At the same time, if a supply voltage is applied and if the movable combs are attracted and shift toward the floor, the capacity between them and the fixed combs increases and an electrostatic force in x-direction appear, trying to align back the combs. It could be shown, that a snap-in of the combs to the bottom substrate can safely be prevented by the designs shown above.

In the following further details of the fabrication technology and process flow for the production of the comb-actuator chips are described.

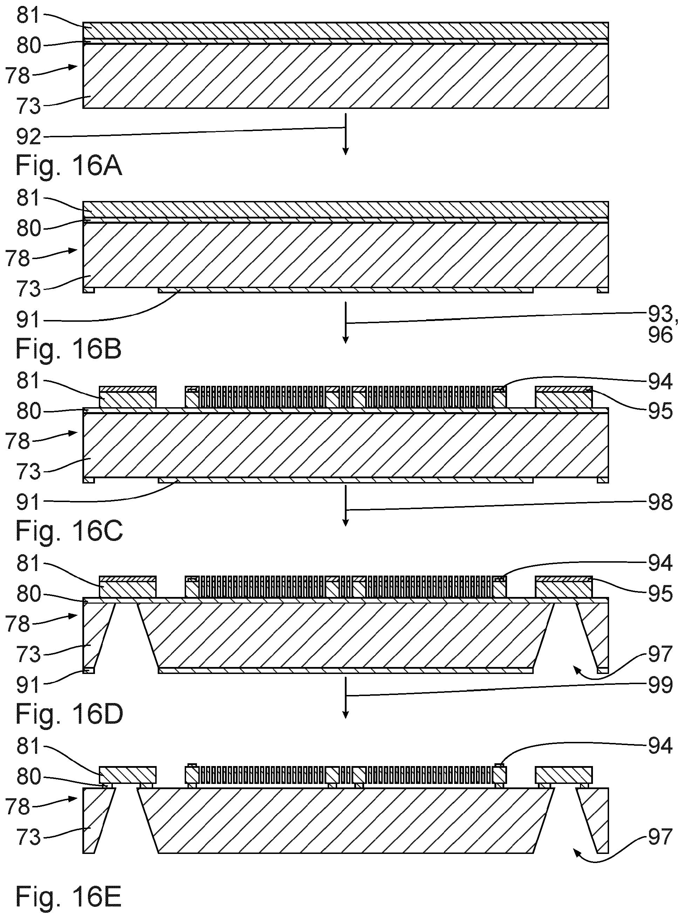

First it is described how a comb-drive chip according to the SOI-based process technology can be realized. As mentioned above, two types of structures can be pre-defined by this tech: 1. densely perforated structures, which can be released by underetching of a sacrificial layer, which, in particular can be made of buried oxide and 2. anchored or fixed structures, which stay on a large base over the floor oxide. The process flow is schematically shown in fig. 16A to E. The pictures show the evolution of a cross-section the chip from fig. 12 along the line XVI - XVI.

The fabrication starts with a SOI wafer 78 with a device layer 81 as thick as high in x will be the structures and a BOX layer 80 with a thickness, similar to the size of the perforation holes 61, e.g. 2-3µm (fig. 16A).

The known and reliable vertical processes for DRIE (deep reactive ion etching), also known as a Bosch process, are reproducible and effective by an aspect ratio of 1:10 up to 1:20. This ratio is reflected by the ratio of the diameter of the holes 61 to the thickness of the device layer 81. More generally, the aspect ratio can be as high as 1:50 and even higher. Generally, the hole size and/or the distance between neighboring holes can be in the range of 1 µm to 10 µm. The comb structures can have a height (hx) in the range of 10 µm to 100 µm, or even up to 200 µm or even higher.

Next, in a back side protection step 92 the back side (BS) of the wafer is protected by a deposited or growth of a SiO₂ layer 91 (fig. 16B). The BS SiO₂ layer 91 is structured lithographically and patterned by a RIE (reactive ion etching) of SiO₂ to define the channel, which separates the chip from the wafer's frame. The photoresist (PR) is stripped away (not shown).

The following preparation steps 93 prepare the front side (FS) of the wafer. As a preliminary step some metallic paths 94 or area must be structured. This involves metal deposition, lithography and etching to form them. Thus, the bonding pads 67 are to be structured. Moreover, thin metallic paths can be placed over the long paths where the future electrical signals must propagate. This can significantly reduce their resistance.

Next comes a lithography step for the definition of the functional and supporting structures: movable 59 and fixed combs 60, the suspension with its free part and the anchors, the pin 52, the wiring Si hills, the bonding pads 67, and the bridges 64 which hold the chip to the frame 69. With the structured PR 95 as a definition mask the device layer is etched vertically by a DRIE process 96 with an etch stop on the BOX 80 (fig. 16C).

Then the bulk chip body is separated. A separation channel 97is etched from the BS: by a dry plasma process 98 (e.g. DRIE), using the structured oxide as an etch mask, or with a double PR + oxide mask, or wet chemically in KOH with an oxide mask (fig. 16D).

By a KOH process the FS of the wafer can be protected in a chuck.

Finally, in a further etching step 99, the wafer is dipped into a BHF (buffered HF acid), which etches anisotropically SiO₂ (fig. 16E).

The process time can be estimated dividing the BOX 80 thickness with the SiO₂ etch ratio. This is the time for which the etch process will go deep up to the bulk (holding) silicon, but also laterally until the next hole. Thus, all vertically defined and perforated structures will be underetched and released.

All structures, which have a base much larger than twice the BOX 80 thickness will remain with a slightly underetched, but solid base. Thus, they remain fixed.

After stripping of the PR 95, the chip is kept to the wafer's frame 69 by the side bridges 64 and can be separated if they are cut, sawed, or just broken.

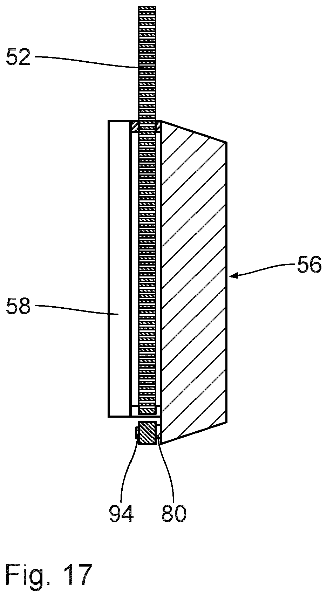

A cross-section of such chip 56 along the pin 52, with a protection cap 58, which can also be structured from Si, is shown in fig. 17.

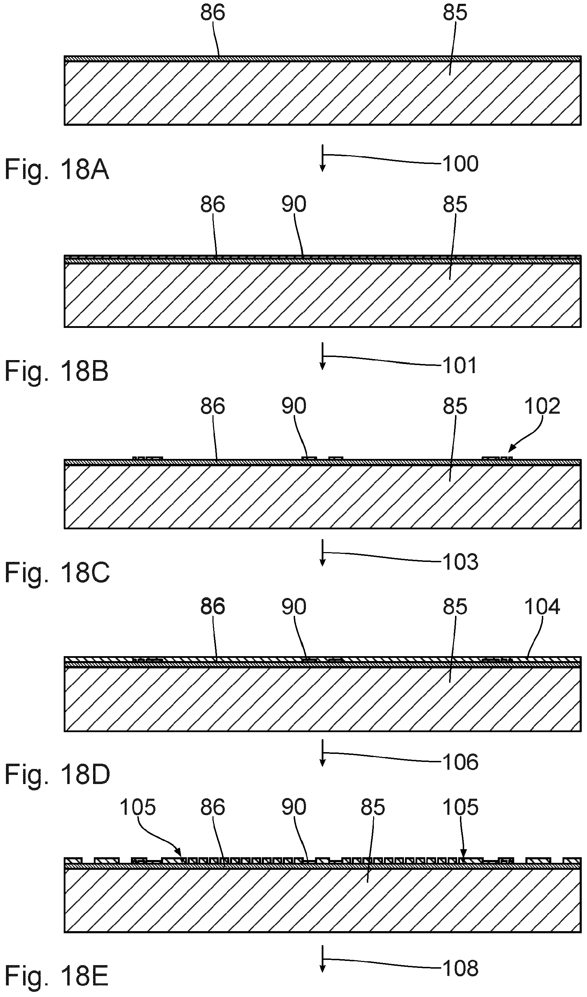

In the following some details of an example for the production of a chip 56 with a poly-Si process (schematically shown in fig. 14) are summarized with reference to fig. 18A to M:
A comb-drive chip shown in fig. 7A can be produced with a poly-Si process technology schematically shown in fig. 14.

For this variant, the fabrication starts with a simple, double-side polished Si wafer (fig. 18A). On its front side (FS) is deposited an electrical isolation layer of silicon nitride (SiNx) layer 86. The SiNx layer 86 can have a thickness of 300 nm to 500 nm. It can be applied by a LPCVD (low pressure chemical vapor deposition) or PECVD (plasma enhanced chemical vapor deposition).

In a deposition step 100 a heavily doped poly-Si layer 90 is deposited on the SiNx layer 86 and structured in a structuring cycle 101 which is also referred to as structuring sequence, (photolithography, RIE of poly-Si, PR stripping) to form the planar interconnections 102 on the substrate (fig. 18C).

The poly-Si layer 90 can have a thickness of 500 nm.

As a next step, deposition step 103, a sacrificial oxide layer 104 is deposited from a gas-phase (gas TEOS = Tetraethyl orthosilicate) under low-pressure or plasma (LPCVD or PECVD process) (fig. 18D).

TEOS SiO₂ deposition up to 5 µm, or even 10 µm is possible.

Optionally, the surface can be planarized by CMP (chemical-mechanical polishing).

After that, optionally, few 1 µm to 3µm small and ~1 µm shallow cone or pyramidal holes 105 can be formed into the oxide (lithography, anisotropic RIE of SiO₂, PR strip). When filled later with poly-Si, they will be x-endstops and will prevent the shuttle of parasitic move and snap-in on the floor.

Further, the areas for the anchors over the isolated floor, and the fixed structures, which must step on the poly-Si wires, must be etched free form the sacrificial oxide. It is done in a structuring step 106, in particular by photolithography and RIE or wet-chemical etching of SiO₂ with a stop on the poly-Si or on the nitride (fig. 18E).

Over the thus produced structures a thick in-situ doped poly-Si layer 107 is deposited in a deposition step 108. It has a thickness corresponding to the height of the combs 59, 60 and the pin 52.

In the considered design, the thickness of the poly-Si layer 107 is 25 µm, but it can be also up to 100 µm, in particular up to 200 µm, or even higher.

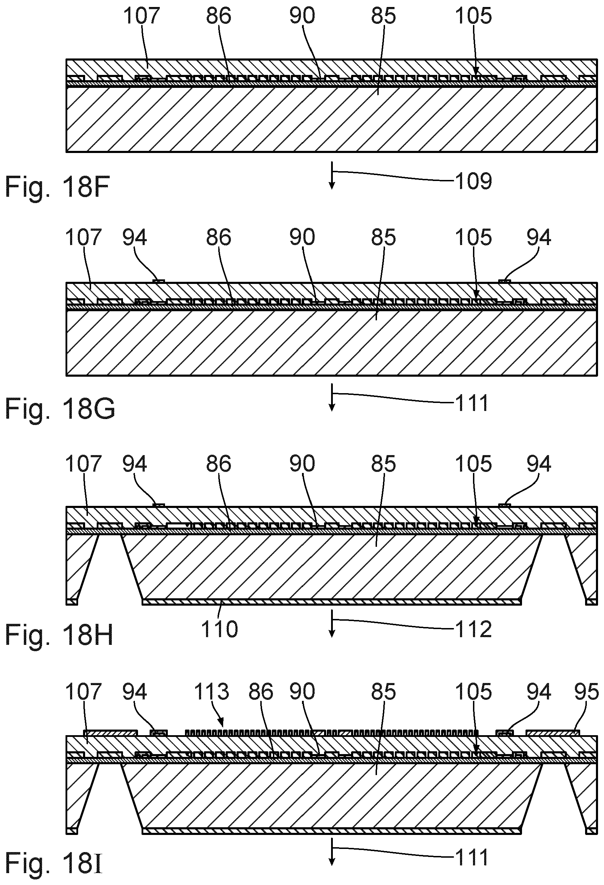

It can be planarized by CMP (fig. 18F).

For the generation 109 of the bonding pads 67 the areas for the future bonding pads 67 must be metalized. For this a deposition of a metal layer 94, e.g. Au or Al, lithographically defined and structured by RIE or wet-chemical etching, or lift-off of metal (fig. 18G).

The chip definition mask must be now formed now on the wafer's back side (BS) by deposition of oxide 110 and its structuring by SiO₂ RIE process 111. The bulk chip body is separated by etching of the surrounding channel 97 from the BS: by a dry plasma process (e.g. DRIE) with the structured oxide, or with a double PR + oxide mask, or wet chemically in KOH with the oxide mask (FS wafer's protection in a chuck necessary) (fig. 18H).

It is followed by a lithography step 112 for the definition of the functional and supporting structures: movable 59 and fixed combs 60, the pin 52, the suspension with its free part and the anchors, the plateaus for the bonding pads 67, and the bridges 64 which hold the chip to the frame 69 (fig. 18I).

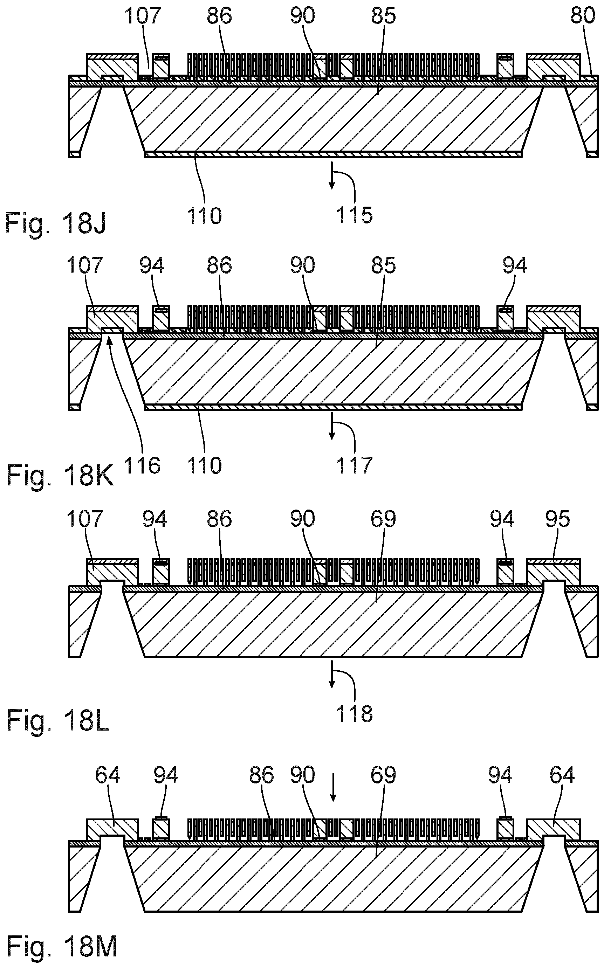

With the structured photoresist (PR) 95 as a definition mask 113 the device layer is etched vertically by a DRIE process 114 with an etch stop on the BOX 80 (fig. 18J).

Next, in an isolation step 115, the nitride isolation 116 is etched by RIE from the BS (fig. 18K).

Then, in a release step 117, the wafer is dipped into a BHF (buffered HF acid), which etches anisotropically the sacrificial SiO₂ (fig. 18L).

This isotropic HF wet chemical process goes deep and at the side, until it meets nitride or poly-Si. Thus, all vertically defined and perforated, or narrow linear structures (e.g. the leaves of the suspension), which stay over a sacrificial oxide, will be underetched and released.

All structures, staying on nitride or poly-Si remain fixed since HF practically does not affect these materials.

After stripping 118 of the PR 95, the chip is kept to the wafer's frame 69 by the side bridges 64 and can be separated if they are cut, sawed, or just broken (fig. 18M).

In the following some details of the arrangement of the actuator devices 53 and assembly concepts are described.

The mirror array 19 according the suggested architecture, as described above, comprises an assembly of the array of flexible connected mirrors 20 with integrated tilt sensors 43 for each mirror 20. The tilt sensors 43 can be micro-structured in silicon. Further the mirror array 19 comprises a holder (supporting structure 54) with pockets 121, providing mechanical support and electrical and thermal connection.

Further, the mirror array 19 comprises the comb drives' chips 56 plugged into these sockets, with the pins 52 in approach or fixed to the mirrors 20.

The holding body (supporting structure 54) provides an electrical connection for the mirror array 19. Through the holding body the sensor signals have to be conducted. The supporting structure 54 further comprises a grounding of the mirrors 20 and an electrical supply to the drive chips 56. In particular, it comprises a plurality of electrical connections and interfacing bond/bump pads. Moreover, it allows the signals rerouting.

The supporting structure 54 is preferably made of a material with a high thermal conductivity, in particular higher than 100 W/(m.K), preferably comparable or higher than that of crystalline Si (149 W/(m.K)), preferably higher than 200 W/(m.K), possibly higher than 300 W/(m.K).

It preferably is solid.

For low-pressure application It preferably has low outgassing.

It can be highly structured for the pockets 121 and openings 55.

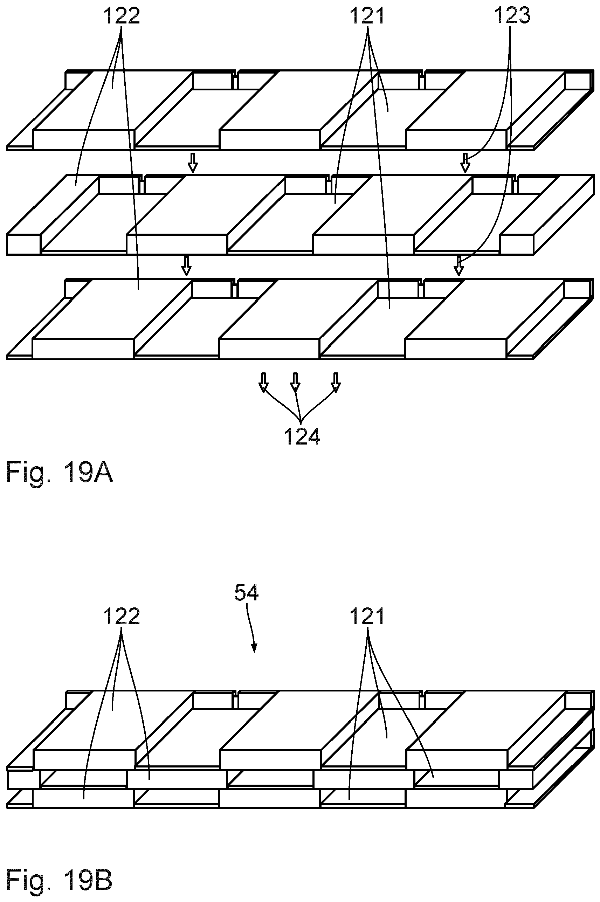

A holder body (supporting structure 54), which can also be referred to as structured plate, can be created as a stack of separate ceramic shells 122 with shifted pattern, aligned and fixed one over the other in an aligning step 123 and a fixing step 124, respectively (fig. 19A, B).

Each shell 122 can have sockets for the drive chip and their pins. In principle there can also be shells 122 without pockets 121.

The space between the shells 122 can be used for planar trough-propagating wires (not shown).

The shells 122 are also referred to as plates. The pockets 121 are also referred to as cavities.

Plates with cavities and wires can be created by the LTCC (low temperature cofire ceramics) technology. LTCC provides for robust assembly and packaging of electronic components, multilayer packaging in the electronics industry, in particular MEMS. The starting material is composite green tapes, consisting of ceramic particles mixed with polymer binders. Metal structures can be added to the layers, commonly using via filling and screen printing. The tapes are flexible and can be machined, for example using cutting, milling, punching and embossing. Individual tapes are then bonded together in a lamination procedure, where the polymer part of the tape is combusted and the ceramic particles sinter together, forming a hard and dense ceramic component.

In general, there are two possibilities for the production of the assembly of the drive chips 56 and the sockets' holder 54.

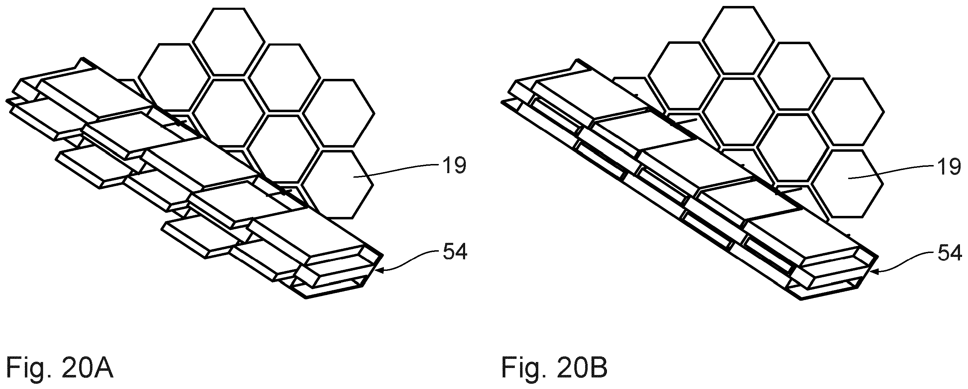

As schematically shown in fig. 20A, B it is possible to align and fix the shells 122 together first and then plug and fix the actuator units 56 into the pockets 121.

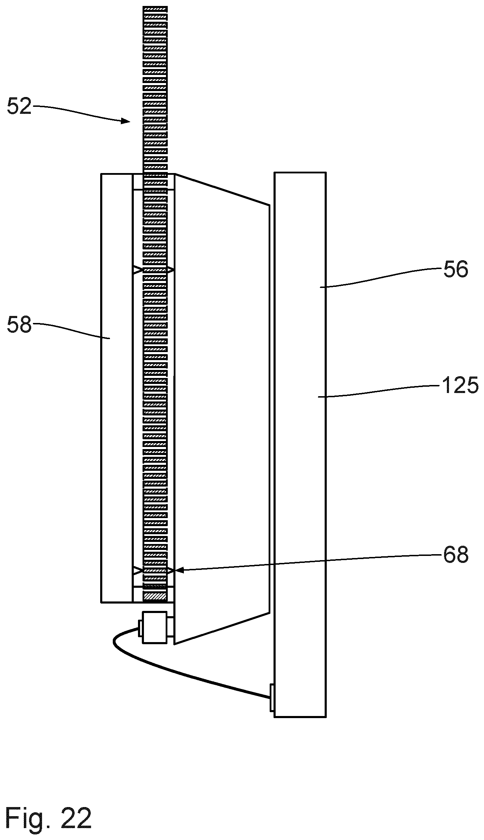

In this variant of the assembly, the chips can be electrically connected after they are fixed, e.g. by a multi-level wire bonding, if their bonding pads 67 are sufficiently accessible, or in advance bonded to individual PCB 125 or ceramic holders as shown in fig. 22. They can then be plugged into the holder 54 and fixed, or the bond pads can be set with bumps, the chips plugged straight and then pressed up or down to be bumped to the holder.

An advantage of this approach is, that the pocked-holder 54 can be mounted first to the element with the mirror array 20, e.g. by bumps in-between. As a next step the mirror array 20 with its ceramic holder 54 can be turned with the mirrors 19 below and the drive chips 56 can be plugged into their sockets (fig. 20A) with the pin 52 through the small socket passage hole 55 at the wall toward the mirrors 19. The actuator chips 56 will slide down until the pins 52 touch the mirrors 19 (fig. 20B).

The pins 52 can be fixed at the mirrors 19, e.g. by gluing or welding, or let free to slide on the mirror's 19 reverse side.

Then the drive chips can be fixed and electrically connected.

By the assembly of the drive chips 56 in the LTCC holder 54 all chips 56 can be arranged in pockets 121. They can in particular all be arranged to be in one level parallel to the mirror's 19 surface. This is particularly advantageous unless the footprint of the actuators is sufficient small to support the mirrors pitch. In particular, if the actuators footprint is larger, the different actuators for every mirror can be ordered in pockets in different levels. This is also possible in general.

For example, it is possible to arrange the actuators for y-tilt in a different plane, in particular below the actuators for x-tilt or vice versa.

Difference in the distance between the actuators 53 and the mirrors 19 can be accounted for by suitably adjusting the lengths of the pins 52 of the different actuators 53. In particular, different actuators 53, in particular different groups of actuators 53, can have pins 52 with different lengths. Here, the lengths of the pins 52 of actuators 53 of the same group can have identical lengths.

If the mirror 19 is tiltable by four actuators 53, two for a x-tilt and two for a y-tilt, the x- and y-actuators can be placed inside different LTCC holders 54 with pockets 121. Within their respective holder 54, the actuators can be mechanically, electrically and thermally connected, e.g. by micro-bumps.

An advantage of such design is, that the actuators for different tilt directions (DoF) can be orientated at angles in-between. This can be achieved by turning the LTCC holder plates in-between and then connecting them. Therefore, the parasitic reaction forces by pushing the mirror can be adjusted to act in the same direction in the local coordinate system of the actuator and to be suspended in the same way by the drive's guidance.

It is particularly beneficial, if the width of the actuator (the longer side of its footprint) is along the radial direction to the pin's contact point. In that case the reaction force when tilting the mirror 19 will act in the comb's y-direction, which is anyway stiff due to the risk of side snap-in.

Generally, it is possible that the drives for different tilt directions differ in their design and/or have pins 52 of different lengths.

It is also possible that all actuators 53 of a given mirror 19, in particular all three or four actuators 53, are placed at different levels. In particular, for the case of 3 driving actuators 53 per mirror 19, it can be advantageous, if they are arranged in 3 different levels.

In particular, actuators 53 of a given mirror 19 can be orientated with their width along the radial direction to the point of the pin's 52 contact. With three actuators 53 for a given mirror 19 they can be arranged turned each at 120 deg with respect to the others.

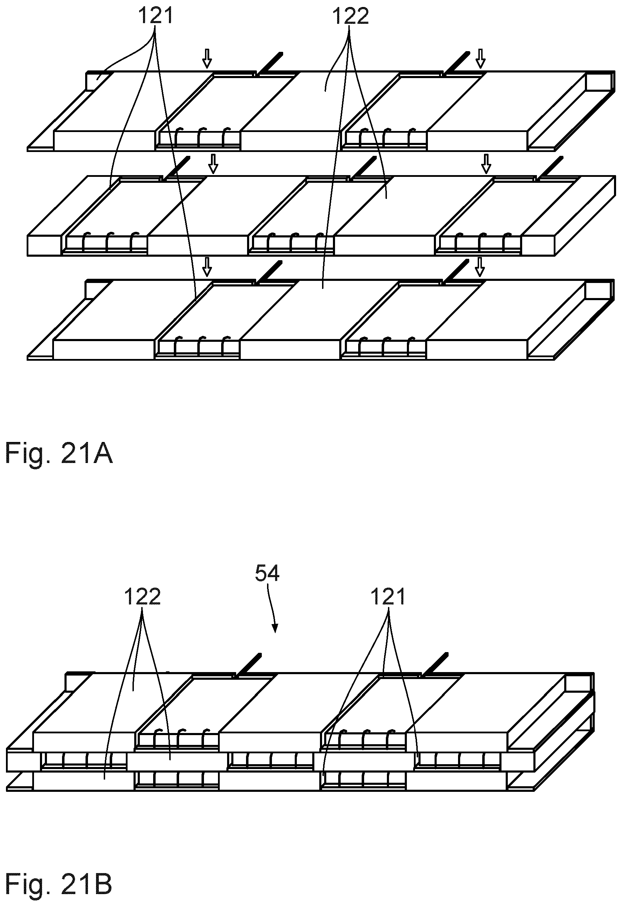

Alternatively, as shown in fig. 21A, B it is possible to place, fix and bond / bump the chips 56 in their beds and then align and stack together the shells 122.

An advantage of this variant is, that the actuator chips 56 are fixed and connected in advance to the LTCC holder 54. Next, the holder 54 can be mounted and connected, in particular bumped, to the mirror array 20 element. This requires fine control of the position and parallelism of the pins of such fixed chips.

Otherwise, due to the tolerances, they can press differently strong the corresponding mirrors, or to stay initially at different distance from the mirrors. Therefore, the mirrors 19 may be pressed and pre-tilt already by the assembly. To correct for such a pre-tilt an individual bias voltage to the actuator of each drive can be applied. In particular, each actuator may have a different setpoint. Thus, it is possible to make sure, that in a base state the pins press equally strong and the mirrors 19 stay parallel to the substrate and all point in one direction.

In the following, some bundling concepts for the mirrors 19 are described.

For parallel manipulation of light, which can lead to advantages for multi-optical beam systems like projectors, multi-beam sawing or welding machine, and especially by the modern lithographic projectors, in particular EUV projection apparatuses, it can be preferable to us arrays 20 of single mirrors 19. The handling is simple and safer, the production is shorter and the assembly - faster and not so risky. Moreover, the arrays of MEMS elements benefit from the parallel processing of all structures within a chip and all chips within a wafer, and the joint processing of a lot of wafers. The size of the array is limited by the yield and the size of one lithographic exposure field.

One implementation for bundling is a hexagonal array of hexagonal mirrors 19, i.e. mirrors 19 with a hexagonal reflection surface. Similar considerations as described below apply for other geometric realizations. In particular, the mirrors 19 can also have a rectangular, in particular a square reflection surface. They can also have a triangular reflection surface. Their reflection surface can in particular be equilateral. Other shapes or embodiments are possible.

The number ntot of mirrors 19 in one such hexagonal array can be calculated as ntot = 1 + sum(6*(k-1)), where k is the number of the shells 122. The number ntot can be e.g. 19, or 91, or 331.

Further, one holder 54 with sockets can support one mirror array 20, but the actuator chips are discrete, and the ceramic holder should embrace them. The parallelism by them is in the processing: the processes are applied for all chips from one wafer, and the wafers from a batch are processed in one series. In the following some aspects of possible shapes of the actuators' holder 54 are described. Preferably, it is possible to fill completely the area of the composite mirror with equal such holders, i.e. with bundles or modules of arrays of hexagonal mirrors with discrete actuators. Generally the mirror arrays 20 have a modular design. They can in particular be embodied as modules, which can be freely combined with each other. This enables an easy replacement, in case some modules turn out to be faulty.

Below, a possible arrangement of the mirrors 19 and their actuators 53 is described with reference to fig. 21.

For hexagonal mirror arrays, if the width (y) of the actuator 53 is comparable or even larger than the size of the mirror 19, the actuator footprint falls partially outside the mirror contour, even if the pin 52 presses the mirror 19 not in the corner, but at smaller arm. In fig. 21A is shown a hexagonal mirror 19. It can have a side length of 3 mm. Also shown is a comb-drive chip 56 with a footprint 4,5 mm x 1 mm which has shown to be feasible by the design and geometry of the combs presented above.

A 19-mirror array is shown in fig. 21B. The mirrors 19 can be arranged with gaps of 0.4 mm.

Further, in the arrangement shown in fig. 21B the pins 52 are each pointed at the middle distance of a corner to the center of a mirror 19. The distance between their contact point with the rear side of the mirrors 19 and the centre of the mirror 19 can be 1.5 mm. Such a drive must provide double force to produce the same torque to the mirror 19. This has been shown to be possible with the design described above.

It can be seen from fig. 21B that 3 such actuators 53 with such arrangement of the pins 52 can be placed behind a mirror 19 without the actuators 53 from the neighboring mirror 19 to intersect or conflict. But it is also visible, that exactly as the hexagonal mirrors 19 cannot embrace their actuators 53 with such footprint, also the hexagonal array (module) following the contour of the outer mirrors 19 cannot embrace the outer actuators 53. There will be some projecting ends 126 of the actuators 53 at the module's edge 127.

Thus, a more complicated form for the holder for the actuators 53 can be preferable. An example of such form is shown in fig. 21C and D. Here, all actuators 53 are completely held inside the outer contour of the holder. The holder can in particular have a jagged edge 127. The contour of the holder can in particular comprise convex and concave parts. The contour of the holder can in particular have a cross-sectional area which is smaller than its smallest convex envelope.

Since the mirrors 19 are positioned in a hexagonal step-and-repeat tessellation, the same applies also for the 19-mirror module or bundle (fig. 21D).

The same rule also holds for larger hexagonal arrays: if the array is created by hexagonal step-and-repeat of the footprint of a mirror with its belonging actuators, and if the actuators do not intersect with their neighbors, the holder shape embracing the actuators can be copied by a multiple step-and-repeat pitch and the bundles will fill complete the 2D space without intersection.

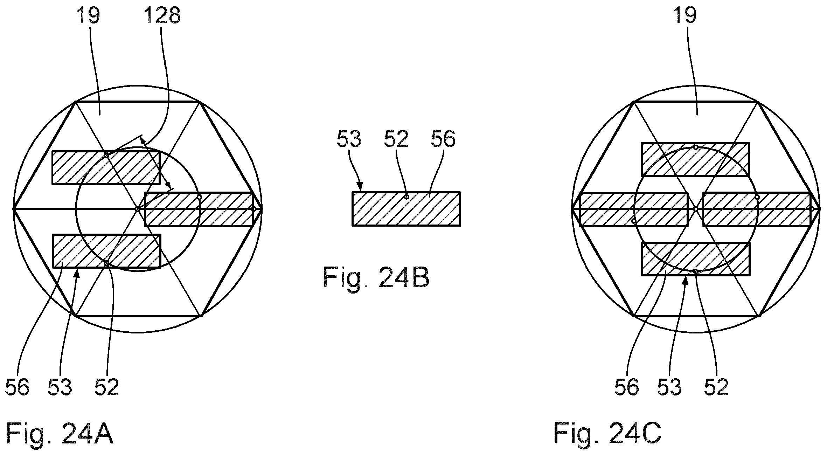

Other arrangements of the actuators 53 relative to the mirrors 19 are shown in fig. 24A and C.

Here, hexagonal mirrors 19 with 3 mm size and actuators 53 (fig. 24B) with a footprint of 2,6 mm x 0,8 mm and arm 1.5 mm corresponding to half of the mirrors 19 side length, are completely hidden behind the mirror 19.

Mirrors 19 with 3 actuators 53 (fig. 24A), or with 4 actuators 53 (fig. 24C), hidden behind, are supported.

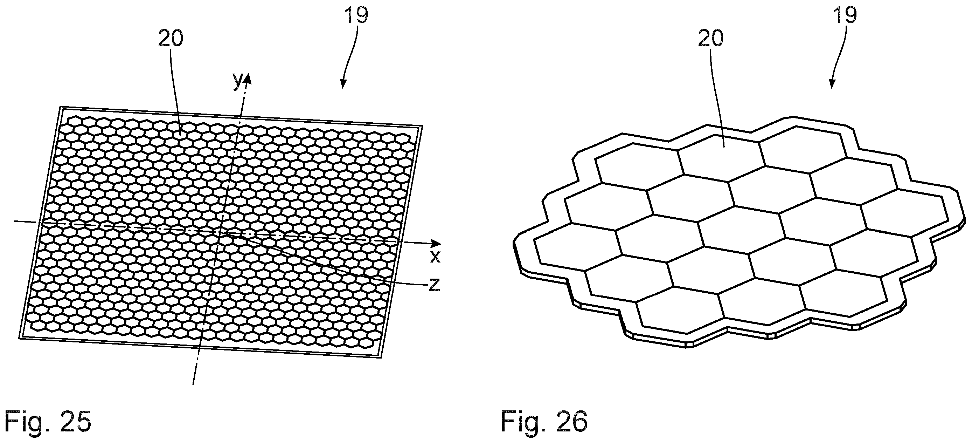

Obviously, bundling of the hexagonal mirror elements in rectangular (fig. 25) or hexagonal arrays (fig. 26) at high fill-factor is possible.

The actuators 53 for every mirror 19 can be arranged at the same level. They can also be arranged at different levels. This would allow larger footprint, but requires difference in the design and the length of the pin 52.

The area of the mirror module can be easily filled by multiple step-and-repeat copy of such mirror elements / mirror modules with hidden actuators. The arrays can be formed triangular, or rectangular, as pentagons or hexagons. They can have straight or zig-zag-sides. The second approach is more complex technically, bur allows denser packing of the arrays/bundles within the mirror module.

Again, it could be shown that the footprint is feasible. The required torque and force can be generated by the actuators 53.

An advantage of a shorter arm 128 length is that a higher tilt range for the mirror 19 can be achieved with the same range of movement. In particular, with an actuation range of the drive of 150 µm a tilt range of 100 mrad could be achieved.

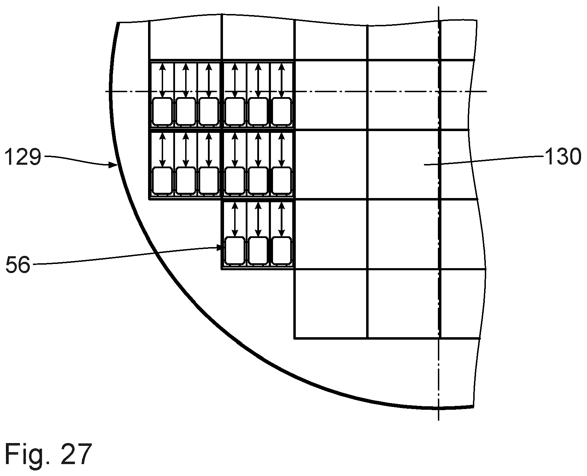

The drives 56 described above can be produced by MEMS processing, in particular by MEMS processing, only. They are MEMS devices. The MEMS devices profit from the parallel processing of all chips in a wafer and from the automated processing of a lot of 25 wafers. The lithography can be done on a stepper: step-and-expose systems, projecting a 5" mask in an exposure field 130 by a size reduction of 1:4 to 1:5. One such field 130 can have a size, depending on the scanner of at least 22 mm x 22 mm, in particular at least 25 mm x 25 mm, in particular up to 32 mm x 32 mm by some more-specialized steppers. Therefore, a 200mm wafer can have 40 to 60 exposure fields 130, depending on their size. A field 130 may contain a plurality of chips, exposed at once. In particular one field 130 can contain 1x3 (shown in fig. 27) to 2x5 comb drives 56. Fig. 27 shows an example of a 1/4 wafer layout 129 with the chips 56. Hence, 120 to 500 or even more chips can be obtained by a single Si wafer by 100% yield or close to 100% yield. Thus, the chips can be produced in a very economical way.

## Claims

1. Micro-optical element (20) comprising
1.1. a body (27) with an optical surface (26),
1.2. a substrate (39) for holding the body (27),
1.2.1. said substrate defining a reference plane with a surface normal (36),
1.3. an actuator device (53) for tilting the micro-optical element (20) around an axis perpendicular to the surface normal (36) by application of a force with a main component parallel to the surface normal (36),
1.4. wherein the body (27) is suspended on the substrate (39) by suspension means,
1.5. wherein the actuator device (53) is arranged on the opposite side of the substrate (39) with respect to the body (27) and
1.6. wherein the actuator device (53) is arranged in a cavity,
**characterised in that**
1.7. the actuator device (53) has
1.7.1. a cross-sectional area perpendicular to the surface normal (36) and
1.7.2. a size (az) along the direction of the surface normal (36),
1.8. wherein the cross-sectional area of the actuator device (53) is smaller than the reflection surface (26) and
1.9. wherein the product of the largest diameter of the cross-sectional area of the actuator device (53) and its size (az) along the direction of the surface normal (36) is larger than the reflection surface (26).

2. Micro-optical element (20) according to claim 1 **characterised in that** the actuator device (53) comprises mechanical means for transferring an actuation force to the body (27), wherein such means have a length (lz) of at least 1 mm in the direction of the surface normal (36).

3. Micro-optical element (20) according to any of claims 1 to 2 **characterised in that** the actuator device (53) is completely arranged within a volume having the same cross-sectional area as the reflection surface.

4. Micro-optical element (20) according to any of claims 1 to 3 **characterised in that** the actuator device (53) comprises a plurality of stacked drives (56).

5. Micro mirror array (MMA) (19)
5.1. a plurality of micro mirror elements (20) according to any of the claims 1 to 4 with mirror plates (27) being suspended on a front side of a substrate (39),
5.2. a supporting structure (54) for providing mechanical support to at least some of the micro mirror elements (20),
5.3. wherein the supporting structure (54) is arranged on the rear side of the substrate (39), and
5.4. wherein the supporting structure (54) comprises cavities (121) for receiving actuator devices (53) for displacing the micro mirror elements (20).

6. MEMS for displacing a micro-optical element (20) comprising
6.1. a substrate (39) for suspending a mirror plate (27) on its front side,
6.2. a supporting structure (54) for mechanically supporting the substrate (39),
6.3. a plurality of actuator devices (53),
6.4. wherein the supporting structure (54) is arranged on the rear side of the substrate (39),
6.5. wherein the actuator devices (53) are arranged within the supporting structure (54),
6.6. wherein each of the actuator device (53) has
6.6.1. a size (az) along the direction of the surface normal (36) and
6.6.2. a cross-sectional area perpendicular to the surface normal (36),
6.7. wherein the cross-sectional area of the actuator device (53) is smaller than the reflection surface (26) and
6.8. wherein the product of the largest diameter of the cross-sectional area of the actuator device (53) and its size (az) along the direction of the surface normal (36) is larger than the reflection surface (26).

7. Facet-mirror for a microlithography system comprising
7.1. a plurality of micro-mirrors in form of micro-optical elements (20) according to any of claims 1 to 4 and/or
7.2. one or more MMA (19) according to claim 5.

8. Method for producing a micro-optical component (20) according to any of the claims 1 to 4 comprising the following steps:
| | |
|---|---|
| 8.1. | providing one or more mirror plates (22), |
| 8.2. | providing a plurality of actuator devices (53) for tilting the mirror plates (22), |
| 8.3. | providing one or more supporting structures (54) with cavities (121) for the arrangement of the actuator devices (53), |
| 8.4. | connecting at least one of the supporting structures (54) to at least one of the mirror plates (22), |
| 8.5. | arranging at least some of the actuator devices (53) in the cavities (121), |
| 8.6. | wherein the actuator devices (53) are arranged in the cavities (121) after the supporting structure (54) has been connected to the mirror plate (22). |

9. Method for producing a micro-optical component (20) according to any of the claims 1 to 4 comprising the following steps:
| | |
|---|---|
| 9.1. | providing one or more mirror plates (22), |
| 9.2. | providing a plurality of actuator devices (53) for tilting the mirror plates (22), |
| 9.3. | providing one or more supporting structures (54) with cavities (121) for the arrangement of the actuator devices (53), |
| 9.4. | connecting at least one of the supporting structures (54) to at least one of the mirror plates (22) |
| 9.5. | arranging at least some of the actuator devices (53) in the cavities (121), |
| 9.6. | wherein the supporting structure (54) is connected to the mirror plate (22) after the actuator devices (53) have been arranged in the cavities (121). |

## Patentansprüche

1. Mikrooptisches Element (20), das Folgendes umfasst
1.1. einen Körper (27) mit einer optischen Oberfläche (26),
1.2. ein Substrat (39) zum Halten des Körpers (27),
1.2.1. wobei das Substrat eine Bezugsebene mit einer Oberflächennormalen (36) definiert,
1.3. eine Aktuatorvorrichtung (53) zum Neigen des mikrooptischen Elements (20) um eine Achse senkrecht zu der Oberflächennormalen (36) durch das Ausüben einer Kraft mit einer Hauptkomponente parallel zur Oberflächennormalen (36),
1.4. wobei der Körper (27) durch Aufhängungsmittel am Substrat (39) aufgehängt ist,
1.5. wobei die Aktuatorvorrichtung (53) auf der dem Körper (27) gegenüberliegenden Seite des Substrats (39) angeordnet ist und
1.6. wobei die Aktuatorvorrichtung (53) in einem Hohlraum (12) angeordnet ist,
**dadurch gekennzeichnet, dass**
1.7. die Aktuatorvorrichtung (53) Folgendes aufweist
1.7.1. eine zur Oberflächennormalen (36) senkrechte Querschnittsfläche und
1.7.2. eine Größe (az) entlang der Richtung der Oberflächennormalen (36),
1.8. wobei die Querschnittsfläche der Aktuatorvorrichtung (53) kleiner als die Reflexionsfläche (26) ist und
1.9. wobei das Produkt aus dem größten Durchmesser der Querschnittsfläche der Aktuatorvorrichtung (53) und ihrer Größe (az) entlang der Richtung der Oberflächennormalen (36) größer als die Reflexionsfläche (26) ist.

2. Mikrooptisches Element (20) nach Anspruch 1, **dadurch gekennzeichnet, dass** die Aktuatorvorrichtung (53) mechanische Mittel zum Übertragen einer Betätigungskraft auf den Körper (27) umfasst, wobei diese Mittel eine Länge (Iz) von wenigstens 1 mm in der Richtung der Oberflächennormalen (36) aufweisen.

3. Mikrooptisches Element (20) nach einem der Ansprüche 1 bis 2, **dadurch gekennzeichnet, dass** die Aktuatorvorrichtung (53) vollständig innerhalb eines Volumens mit der gleichen Querschnittsfläche wie die Reflexionsfläche angeordnet ist.

4. Mikrooptisches Element nach einem der Ansprüche 1 bis 4, **dadurch gekennzeichnet, dass** die Aktuatorvorrichtung (53) mehrere gestapelte Antriebe (56) umfasst.

5. Mikrospiegelanordnung (MMA) (19):
5.1. mehrere Mikrospiegelelemente (20) nach einem der Ansprüche 1 bis 4 mit Spiegelplatten (27), die an einer Vorderseite eines Substrats (39) aufgehängt sind, und
5.2. eine Tragstruktur (54) zum Bereitstellen einer mechanischen Stütze für wenigstens einige der Mikrospiegelelemente (20),
5.3. wobei die Tragstruktur (54) auf der Rückseite des Substrats (39) angeordnet ist, und
5.4. wobei die Tragstruktur (54) Hohlräume (12) zum Aufnehmen von Aktuatorvorrichtungen (53) zum Auslenken der Mikrospiegelelemente (20) umfasst.

6. MEMS zum Auslenken eines optischen Elements (20), wobei das MEMS Folgendes umfasst:
6.1. ein Substrat (39) zum Aufhängen einer Spiegelplatte (27) an seiner Vorderseite,
6.2. eine Tragstruktur (54) zum mechanischen Tragen des Substrats (39),
6.3. mehrere Aktuatorvorrichtungen (53),
6.4. wobei die Tragstruktur (54) auf der Rückseite des Substrats (39) angeordnet ist,
6.5. wobei die Aktuatorvorrichtungen (53) innerhalb der Tragstruktur (54) angeordnet sind,
6.6. wobei jede Aktuatorvorrichtung (53) Folgendes aufweist:
6.6.1 eine Größe (az) entlang der Richtung der Oberflächennormalen (36), und
6.6.2 eine zur Oberflächennormalen (36) senkrechte Querschnittsfläche,
6.7. wobei die Querschnittsfläche der Aktuatorvorrichtung (53) kleiner als die Reflexionsfläche (26) ist und
6.8. wobei das Produkt aus dem größten Durchmesser der Querschnittsfläche der Aktuatorvorrichtung (53) und ihrer Größe (az) entlang der Richtung der Oberflächennormalen (36) größer als die Reflexionsfläche (26) ist.

7. Facettenspiegel für ein Mikrolithographiesystem, der Folgendes umfasst
7.1. mehrere Mikrospiegel in der Form von mikrooptischen Elementen (20) nach einem der Ansprüche 1 bis 4 und/oder
7.2. eine oder mehrere MMA (19) nach Anspruch 5.

8. Verfahren zur Herstellung einer mikrooptischen Komponente (20) nach einem der Ansprüche 1 bis 4, das die folgenden Schritte umfasst:
8.1. Bereitstellen einer oder mehrerer Spiegelplatten (22),
8.2. Bereitstellen mehrerer Aktuatorvorrichtungen (53) zum Neigen der Spiegelplatten (22),
8.3. Bereitstellen einer oder mehrerer Tragstrukturen (54) mit Hohlräumen (121) für die Anordnung der Aktuatorvorrichtungen (53),
8.4.Verbinden wenigstens einer der Tragstrukturen (54) mit wenigstens einer der Spiegelplatten (22),
8.5. Anordnen wenigstens einiger der Aktuatorvorrichtungen (53) in den Hohlräumen(121),
8.6. wobei die Aktuatorvorrichtungen (53) in den Hohlräumen (121) angeordnet werden, nachdem die Tragstruktur (54) mit der Spiegelplatte (22) verbunden worden ist.

9. Verfahren zur Herstellung einer mikrooptischen Komponente (20) nach einem der Ansprüche 1 bis 4, das die folgenden Schritte umfasst:
9.1. Bereitstellen einer oder mehrerer Spiegelplatten (22),
9.2. Bereitstellen mehrerer Aktuatorvorrichtungen (53) zum Neigen der Spiegelplatten (22),
9.3. Bereitstellen einer oder mehrerer Tragstrukturen (54) mit Hohlräumen (121) für die Anordnung der Aktuatorvorrichtungen (53),
9.4.Verbinden wenigstens einer der Tragstrukturen (54) mit wenigstens einer der Spiegelplatten (22),
9.5. Anordnen wenigstens einiger der Aktuatorvorrichtungen (53) in den Hohlräumen (121),
9.6. wobei die Tragstruktur (54) mit der Spiegelplatte (22) verbunden wird, nachdem die Aktuatorvorrichtungen (53) in den Hohlräumen (121) angeordnet worden sind.

## Revendications

1. Microélément optique (20) comprenant
1.1. un corps (27) avec une surface optique (26),
1.2. un substrat (39) destiné à soutenir le corps (27),
1.2.1. ledit substrat définissant un plan de référence avec une normale à la surface (36),
1.3. un dispositif d'actionnement (53) destiné à incliner le microélément optique (20) autour d'un axe perpendiculaire à la normale à la surface (36) par application d'une force avec une composante principale parallèle à la normale à la surface (36),
1.4. dans lequel le corps (27) est suspendu sur le substrat (39) par des moyens de suspension,
1.5. dans lequel le dispositif d'actionnement (53) est disposé sur le côté opposé du substrat (39) par rapport au corps (27) et
1.6. dans lequel le dispositif d'actionnement (53) est disposé dans une cavité,
**caractérisé en ce que**
1.7. le dispositif d'actionnement (53) présente
1.7.1. une aire de section transversale perpendiculaire à la normale à la surface (36) et
1.7.2. une taille (az) le long de la direction de la normale à la surface (36),
1.8. dans lequel l'aire de section transversale du dispositif d'actionnement (53) est inférieure à la surface de réflexion (26) et
1.9. dans lequel le produit du plus grand diamètre de l'aire de section transversale du dispositif d'actionnement (53) et de sa taille (az) le long de la direction de la normale à la surface (36) est supérieur à la surface de réflexion (26).

2. Microélément optique (20) selon la revendication 1 **caractérisé en ce que** le dispositif d'actionnement (53) comprend des moyens mécaniques pour transférer une force d'actionnement au corps (27), de tels moyens présentant une longueur (1z) d'au moins 1 mm dans la direction de la normale à la surface (36).

3. Microélément optique (20) selon l'une quelconque des revendications 1 à 2 **caractérisé en ce que** le dispositif d'actionnement (53) est entièrement disposé à l'intérieur d'un volume ayant la même aire de section transversale que la surface de réflexion.

4. Microélément optique (20) selon l'une quelconque des revendications 1 à 3 **caractérisé en ce que** le dispositif d'actionnement (53) comprend une pluralité de dispositifs d'entraînement empilés (56).

5. Réseau de micromiroirs (MMA) (19)
5.1. une pluralité de microéléments miroirs (20) selon l'une quelconque des revendications 1 à 4 avec des plaques miroirs (27) suspendues sur un côté avant d'un substrat (39),
5.2. une structure de support (54) destinée à assurer un support mécanique à au moins certains des microéléments miroirs (20),
5.3. dans lequel la structure de support (54) est disposée sur le côté arrière du substrat (39), et
5.4. dans lequel la structure de support (54) comprend des cavités (121) destinées à recevoir des dispositifs d'actionnement (53) servant à déplacer les microéléments miroirs (20).

6. MEMS destiné à déplacer un microélément optique (20) comprenant
6.1. un substrat (39) destiné à suspendre une plaque miroir (27) sur son côté avant,
6.2. une structure de support (54) destinée à supporter mécaniquement le substrat (39),
6.3. une pluralité de dispositifs d'actionnement (53),
6.4. dans lequel la structure de support (54) est disposée sur le côté arrière du substrat (39),
6.5. dans lequel les dispositifs d'actionnement (53) sont disposés à l'intérieur de la structure de support (54),
6.6. dans lequel chacun des dispositifs d'actionnement (53) présente
6.6.1. une taille (az) le long de la direction de la normale à la surface (36) et
6.6.2. une aire de section transversale perpendiculaire à la normale à la surface (36),
6.7. dans lequel l'aire de section transversale du dispositif d'actionnement (53) est inférieure à la surface de réflexion (26) et
6.8. dans lequel le produit du plus grand diamètre de l'aire de section transversale du dispositif d'actionnement (53) et de sa taille (az) le long de la direction de la normale à la surface (36) est supérieur à la surface de réflexion (26).

7. Miroir à facettes pour un système de microlithographie comprenant
7.1. une pluralité de micromiroirs sous forme de microéléments optiques (20) selon l'une quelconque des revendications 1 à 4 et/ou
7.2. un ou plusieurs MMA (19) selon la revendication 5.

8. Procédé destiné à produire un microcomposant optique (20) selon l'une quelconque des revendications 1 à 4 comprenant les étapes suivantes :
8.1. obtention d'une ou plusieurs plaques miroirs (22),
8.2. obtention d'une pluralité de dispositifs d'actionnement (53) destinés à incliner les plaques miroirs (22),
8.3. obtention d'une ou plusieurs structures de support (54) avec des cavités (121) pour la disposition des dispositifs d'actionnement (53),
8.4. raccordement d'au moins une des structures de support (54) à au moins une des plaques miroirs (22), 8.5. disposition d'au moins certains des dispositifs d'actionnement (53) dans les cavités (121),
8.6. dans lequel les dispositifs d'actionnement (53) sont disposés dans les cavités (121) après que la structure de support (54) a été raccordée à la plaque miroir (22).

9. Procédé destiné à produire un microcomposant optique (20) selon l'une quelconque des revendications 1 à 4 comprenant les étapes suivantes :
9.1. obtention d'une ou plusieurs plaques miroirs (22),
9.2. obtention d'une pluralité de dispositifs d'actionnement (53) destinés à incliner les plaques miroirs (22),
9.3. obtention d'une ou plusieurs structures de support (54) avec des cavités (121) pour la disposition des dispositifs d'actionnement (53),
9.4. raccordement d'au moins une des structures de supports (54) à au moins une des plaques miroirs (22),
9.5. disposition d'au moins certains des dispositifs d'actionnement (53) dans les cavités (121),
9.6. dans lequel la structure de support (54) est raccordée à la plaque miroir (22) après que les dispositifs d'actionnement (53) ont été disposés dans les cavités (121).
